# EUROPÄISCHE PATENTSCHRIFT

(11) **EP 1 879 071 B1**
(45) Veröffentlichungstag und Bekanntmachung des Hinweises auf die Patenterteilung: **12.06.2013**
(21) Anmeldenummer: 07013477.0
(22) Anmeldetag: 10.07.2007
(51) Int. Cl.: G03F 7/20

(54) **Beleuchtungsoptik für eine Mikrolithografie-Projektionsbelichtungsanlage**
Illumination optics for a micro lithographic projection illumination system
Optique d'éclairage pour une installation d'éclairage par projection pour microlithographie

(30) Priorität: 14.07.2006 DE 102006032810; 07.02.2007 US 888647 P
(43) Veröffentlichungstag der Anmeldung: 16.01.2008
(73) Patentinhaber: Carl Zeiss SMT GmbH, 73447 Oberkochen (DE)
(72) Erfinder: Kohl, Alexander, Dr., 73460 Hüttlingen (DE)
(74) Vertreter: Hofmann, Matthias

(56) Entgegenhaltungen:
- EP-A- 2 040 283
- WO-A-2007/119839
- JP-A- 2000 021 748
- US-A1- 2007 146 676
- US-B1- 6 383 940

## Beschreibung

Die Erfindung betrifft ein Beleuchtungssystem mit einer Beleuchtungsoptik für eine Mikrolithografie-Projektionsbelichtungsanlage. Weiterhin betrifft die Erfindung eine Mikrolithografie-Projektionsbelichtungsanlage mit einem solchen Beleuchtungssystem. Ferner betrifft die Erfindung ein mikrolithografisches Herstellungsverfahren für mikrostrukturierte Bauelemente.

Die Leistungsfähigkeit von Projektionsbelichtungsanlagen für die mikrolithografische Herstellung von Halbleiterbauelementen und anderen fein strukturierten Bauteilen wird wesentlich durch die Abbildungseigenschaften der Projektionsobjektive bestimmt. Darüber hinaus werden die Bildqualität, die Flexibilität der Verfahrensführung, der mit der Anlage erzielbare Wafer-Durchsatz und andere Leistungsmerkmale wesentlich durch Eigenschaften des dem Projektionsobjektiv vorgeschalteten Beleuchtungssystems mitbestimmt. Diese sollte in der Lage sein, das Licht einer primären Lichtquelle, beispielsweise eines Lasers, mit möglichst hohem Wirkungsgrad zu präparieren und dabei in einem Beleuchtungsfeld des Beleuchtungssystems eine möglichst gleichmäßige Intensitätsverteilung zu erzeugen. Zudem soll es möglich sein, am Beleuchtungssystem verschiedene Beleuchtungsmodi einzustellen, um beispielsweise die Beleuchtung entsprechend der Strukturen der einzelnen abzubildenden Vorlagen, also von Masken oder Retikeln, zu optimieren. Üblich sind Einstellungsmöglichkeiten zwischen unterschiedlichen konventionellen Beleuchtungssettings mit verschiedenen Kohärenzgraden sowie Ringfeldbeleuchtung und Dipol- oder Quadropolbeleuchtung. Die nicht-konventionellen Beleuchtungssettings zur Erzeugung einer schiefen Beleuchtung können u. a. der Erhöhung der Tiefenschärfe durch Zweistrahlinterferenz sowie der Erhöhung des Auflösungsvermögens dienen.

Mikrolithografische Beleuchtungssysteme sind bekannt aus der EP 0 747 772 A, der US 6 900 943 B2, der US 6 285 442 B1, der US 4 851 882, der US 4 947 030, der US 6 657 787 B1, der WO 2005/027207 A1, der DE 199 21 795 A1, der US 2006/0055834 A1, der WO 2006/040184 A2, der JP 2000 021 748 A, der US 6 383 940 B1 und der US 2007/146 676 A1.

Für Mehrfachbelichtungen können schnelle Wechsel des Beleuchtungssettings erwünscht sein, um in kurzen Zeiten die Maske mit zwei unterschiedlichen Beleuchtungssettings zu beleuchten. Die Möglichkeiten herkömmlicher Beleuchtungssysteme mit variabel einstellbaren Pupillenformungseinrichtungen sind in dieser Hinsicht begrenzt, insbesondere wenn für den Wechsel zwischen unterschiedlichen Beleuchtungssettings relativ lange Verfahrwege für die Massen der verschiebbaren optischen Komponenten zurückgelegt werden müssen. Bei einem Einsatz von auswechselbaren Pupillenfiltern muss Lichtverlust in Kauf genommen werden.

Es ist eine Aufgabe der Erfindung, ein Beleuchtungssystem für eine Mikrolithografie-Projektionsbelichtungsanlage bereit zu stellen, das einen schnellen Wechsel zwischen unterschiedlichen Beleuchtungssettings, möglichst innerhalb von Sekundenbruchteilen und im Wesentlichen ohne Lichtverlust ermöglicht.

Diese Aufgabe ist erfindungsgemäß gelöst durch ein Beleuchtungssystem mit den im Anspruch 1 angegebenen Merkmalen und durch ein Beleuchtungssystem mit den im Anspruch 2 angegebenen Merkmalen.

Erfindungsgemäß wurde erkannt, dass auf einen aufwändigen Wechsel zwischen optischen Konfigurationen innerhalb einer optischen Baugruppe verzichtet werden kann, wenn mindestens zwei optische Baugruppen, die bereits zur Vorgabe bestimmter Beleuchtungssettings vorjustiert sind, vorbereitet sind, zwischen denen nach Bedarf gewechselt werden kann. Dieser Wechsel zwischen den optischen Baugruppen kann mechanisch, z. B. durch das zeitweilige Einbringen eines Spiegels in den Beleuchtungs-Lichtweg, oder auch durch die Änderung einer Lichteigenschaft des Beleuchtungslichts erfolgen. Auf diese Weise werden auch voneinander verschiedene Beleuchtungssettings mit geringem Umstellaufwand zugänglich. Dies kann für anspruchsvolle Projektionsaufgaben genutzt werden. Als Einkoppelelement kann ein Einkoppel-Strahlteiler oder auch ein zusammenführendes optisches Element in Form einer Linse, eines Objektivs oder eines Spiegels eingesetzt werden, wie dies aus der WO 2005/027207 A1 bekannt ist. Erfindungsgemäß ist auch ein Wechsel zwischen mehr als zwei optischen Baugruppen, z. B. durch kaskadierte Auskoppel- und Einkoppelelemente, möglich. Damit einher geht die Möglichkeit eines Wechsels zwischen mehr als zwei verschiedenen Beleuchtungssettings. Die Steuereinrichtung erlaubt die anteilsmäßige Vorgabe der Beleuchtung des Beleuchtungsfeldes mit verschiedenen vorgegebenen Beleuchtungssettings. Die Anteile können durch zeitanteiliges Beleuchten, also durch sequentielles Beleuchten zunächst mit einem ersten und dann mit mindestens einem weiteren Beleuchtungssetting, oder durch intensitätsanteiliges Beleuchten, also durch paralleles Beleuchten des Beleuchtungsfeldes mit mehreren Beleuchtungssettings mit vorgegebener Intensitätsverteilung, realisiert werden. Sofern es zur Realisierung des Wechsels zwischen den optischen Baugruppen erforderlich ist, kann die zentrale Steuereinrichtung auch mit dem Einkoppelelement zur Ansteuerung in Signalverbindung stehen.

Ein mechanisches Verlagern optischer Komponenten zum Wechsel zwischen zwei unterschiedlichen Beleuchtungssettings ist entbehrlich, wenn nach Anspruch 2 über einen Auskoppel- und einen Einkoppelstrahlteiler optisch zwischen Lichtwegen gewechselt wird, in denen fertig vorjustierte, verschiedene optische Baugruppen jeweils zum Einstellen eines bestimmten Beleuchtungssettings vorgesehen sind. Der Wechsel zwischen den Lichtwegen geschieht in diesem Fall durch Änderung einer Lichteigenschaft. Hierbei kann es sich um die Lichtpolarisation, die Lichtwellenlänge, die Richtung des Lichtbündels oder auch die Bündelgeometrie handeln. Insbesondere ist auch, zum Beispiel durch kaskadierte Lichteigenschafts-Wechseleinrichtungen ein Wechsel zwischen mehr als zwei Lichteigenschaften möglich. Es kann bei erfindungsgemäßen Varianten also auch zwischen mehr als zwei optischen Baugruppen und damit zwischen mehr als zwei verschiedenen Beleuchtungssettings schnell gewechselt werden.

Bei der Lichteigenschaft kann es sich um einen Polarisationszustand des Lichtes handeln. Die Lichteigenschafts-Wechseleinrichtung kann in diese eintretendes Beleuchtungslicht je nach Schaltung in Licht mit einem ersten oder einem zweiten Polarisationszustand überführen. Der Auskoppel-Strahlteiler und der Einkoppel-Strahlteiler können jeweils als polarisationsselektive Strahlteiler ausgeführt sein. Ein Polarisationszustands-Wechsel durch die Lichteigenschafts-Wechseleinrichtung kann extrem schnell, zum Beispiel innerhalb weniger einzelner Nanosekunden, hergestellt werden. Wenn alternativ die Lichtwellenlänge als zu wechselnde Lichteigenschaft herangezogen wird, werden als ein- bzw. auskoppelnde Strahlteiler dichroitische Strahlteiler eingesetzt. Beim Einsatz der Bündelrichtung oder Bündelgeometrie des Beleuchtungslichts als zu ändernde Lichteigenschaft können als ein- bzw. auskoppelnde Strahlteiler reflektierende Schneiden-Anordnungen eingesetzt werden.

Die Beleuchtungsoptik kann einen polarisationsselektiven Strahlteiler aus der Gruppe: Polarisationswürfel oder Strahlteilerplatten aufweisen. Ein derartiger polarisationsselektiver Strahlteiler kann ein Beleuchtungs-Lichtbündel mit großem Querschnitt führen, was zu einer vorteilhaften niedrigen Energie- bzw. Intensitätsbelastung des Strahlteilers führt. Der bei einer Variante eingesetzte Polarisationswürfel bzw. Strahlteilerwürfel kann, je nach eingesetzter Beleuchtungslicht-Wellenlänge, aus CaF₂ oder auch aus Quarz ausgeführt sein. Alternativ kann auch eine beispielsweise optisch beschichtete Strahlteilerplatte eingesetzt sein, die Licht einer ersten Polarisationsrichtung durchlässt und Licht einer zweiten Polarisationsrichtung reflektiert.

Die Lichteigenschafts-Wechseleinrichtung kann als Pockelszelle ausgeführt sein. Eine Pockelszelle nach hat sich zum schnellen Schalten von Polarisationszuständen in anderen Anwendungen bewährt. Alternativ kann auch eine Kerr-Zelle eingesetzt werden, die sich auch zur Änderung der Bündelgeometrie eignet. Zur Änderung der Bündelrichtung kann als Lichteigenschafts-Wechseleinrichtung ein akustooptischer Modulator eingesetzt sein, wobei die Bündelrichtung über Bragg-Reflexionen geändert wird.

Die Lichteigenschafts-Wechseleinrichtung kann so ausgestaltet sein, dass ein Wechsel der Lichteigenschaft innerhalb von einer sec., bevorzugt innerhalb von einer ms, bevorzugt innerhalb von 100 ns, noch mehr bevorzugt innerhalb von 10 ns möglich ist. Die Lichteigenschafts-Wechseleinrichtung kann so ausgestaltet sein, dass ein periodischer Wechsel der Lichteigenschaften erfolgt. Die Lichteigenschafts-Wechseleinrichtung kann so ausgestaltet sein, dass ein Wechsel der Lichteigenschaft mit einer Umschaltfrequenz erfolgt, die größer ist als 1 Hz, bevorzugt größer als 1 kHz, mehr bevorzugt größer ist als 10 kHz. Derartige Lichteigenschaftswechsel erlauben gut angepasst an die zeitliche Form der Lichtemission gebräuchlicher Lichtquellen einen zur Verteilung der Lichtbelastung auf die optischen Komponenten besonders gut geeigneten Lichteigenschaftswechsel.

Polarisations-Wechseleinrichtungen nach den Ansprüchen 4 und 5 stellen Beispiele für eine Lichteigenschafts-Wechseleinrichtung dar, bei der die Lichteigenschaft durch ein mechanisches Umstellen einer optischen Komponente gewechselt wird. Die Polarisations-Wechseleinrichtung kann als Lambda/2-Platte ausgeführt sein, die um eine Strahlachse des Beleuchtungslichts drehbar ist. Die Polarisations-Wechseleinrichtung der Beleuchtungsoptik kann aus mindestens einem optischen Element aus optisch aktivem Material bestehen. Alternativ oder zusätzlich können die mindestens zwei voneinander räumlich getrennten, unterschiedlich wirkenden polarisationsoptischen Komponenten der Beleuchtungsoptik aneinander anstoßen oder zumindest bereichsweise graduell ineinander übergehen. Auch bei derartigen Polarisations-Wechseleinrichtungen kann die Lichteigenschaft durch ein mechanisches Umstellen einer optischen Komponente gewechselt werden. Bei diesen verschiedenen Varianten der Polarisations-Wechseleinrichtung kann die optische Komponente so umgestellt werden, dass das Beleuchtungslicht vor und nach der Umstellung die gleiche optisch aktive Fläche der optischen Komponente durchtritt. Dies ist beispielsweise bei der Verwendung einer einzigen Lambda/2-Platte als Polarisations-Wechseleinrichtung der Fall. Bei anderen Ausführungen der Lichteigenschafts-Wechseleinrichtung werden verschiedene optisch aktive Bereiche der optischen Komponente durch das mechanische Umstellen genutzt. Der Ansteuerungsaufwand für eine derartige Lichteigenschafts-Wechseleinrichtung ist relativ niedrig.

Als zweite polarisationsoptische Komponente der Polarisations-Wechseleinrichtung kann mindestens eineLambda/2-Platte vorgesehen sein. Eine derartige zweite polarisationsoptische Komponente führt wie z. B. eine Polarisations-Wechseleinrichtung, die als Lambda/2-Platte ausgeführt ist, die um eine Strahlachse des Beleuchtungslichts drehbar ist, zur Möglichkeit einer Auskopplung des Beleuchtungslichts mit Hilfe eines polarisationsoptischen Strahlteilers. Bei der ersten polarisationsoptischen Komponente der Polarisations-Wechseleinrichtung kann es sich ebenfalls um eine Lambda/2-Platte mit im Vergleich zur zweiten polarisationsoptischen Komponente in der Betriebsposition anders orientierter optischer Achse handeln. Im einfachsten Fall handelt es sich bei der ersten polarisationsoptischen Komponente einfach um einen freien Durchgang durch die Polarisations-Wechseleinrichtung.

Bei einem Auskoppelelement nach Anspruch 6 wird zwischen den beiden optischen Baugruppen durch zeitweiliges Einfügen eines Spiegels in den Strahlengang des Beleuchtungslichts gewechselt. Diese Variante erfordert eine relativ unaufwändige Ansteuerung.

Das Auskoppelelement der Beleuchtungsoptik kann eine Mehrzahl von Einzelspiegeln aufweisen, die auf einem drehantreibbaren Spiegelträger angeordnet sind. Beispiele für solche Auskoppelelemente sind aus der Messtechnik oder aus der optischen Scanner-Technik bekannt.

Das Auskoppelelement der Beleuchtungsoptik kann als bandförmige Spiegelfolie ausgebildet sein, die Einzelspiegel trägt, zwischen denen transparente Lücken ausgebildet sind. Ein solches Auskoppelelement kann mit relativ geringer zu bewegender Masse realisiert werden.

Die Einkoppelelemente können entsprechend diesen Auskoppelelementen ausgeführt sein.

In der Regel sind nach Anspruch 7 das erste Beleuchtungssetting und das zweite Beleuchtungssetting voneinander verschieden. Bei manchen Anwendungen kann es sich beim zweiten Beleuchtungssetting jedoch auch um exakt bzw. im Rahmen vorgegebener Toleranzgrenzen um das gleiche Beleuchtungssetting handeln wie das erste Beleuchtungssetting, sodass sich das erste Beleuchtungssetting vom zweiten Beleuchtungssetting in keiner Lichteigenschaft nennenswert unterscheidet. Der Wechsel zwischen den Beleuchtungssettings führt in derartigen Fällen immer noch zu einer Reduzierung der optischen Belastung der Komponenten der ersten und der zweiten optischen Baugruppe, da diese optischen Baugruppen nur mit jeweils einem Teil des gesamten Beleuchtungslichts beaufschlagt werden. Im Sinne der vorliegenden Anmeldung sind Beleuchtungssettings auch dann unterschiedlich, wenn sie sich ausschließlich in der Polarisation des dem Objektfeld zugeführten Beleuchtungslichts unterscheiden. Ein derartiger Polarisationsunterschied kann ein Unterschied in der Polarisationsart des durch einen lokalen Punkt in einer Pupille der Beleuchtungsoptik hindurchtretenden Lichts sein. Die Pupille ist dabei der vom Beleuchtungslicht durchtretene Bereich einer Pupillenebene, die wiederum zu einer Pupillenebene einer der Beleuchtungsoptik nachgeschalteten Optik, insbesondere einer Projektionsoptik, optisch konjugiert ist. Alternativ oder zusätzlich kann ein Polarisationsunterschied auch ein Unterschied in der räumlichen Verteilung der Ausrichtung der Polarisationsart gegenüber dem Koordinatensystem der Pupille über die verschiedenen lokalen Punkte der Pupille hinweg sein. Unter Polarisationsart, Polarisationstyp oder Polarisationszustand wird hierbei linear und/oder zirkular polarisiertes Licht verstanden sowie jede Form von Kombinationen hiervon, wie zum Beispiel elliptisch, tangential und/oder radial polarisiertes Licht. Es ist beispielsweise möglich, in einem ersten Beleuchtungssetting das gesamte Objektfeld mit einem ersten über die Pupille konstanten, linearen Polarisationszustand des Beleuchtungslichts zu bestrahlen. Bei einem zweiten Beleuchtungssetting wird Licht mit einer hierzu bezüglich einer Drehachse um einen konstanten Winkel, beispielsweise um 90° gedrehten Polarisation benutzt. Die Polarisationsverteilung ist in diesem Falle invariant unter Drehung um den genannten konstanten Winkel um die Drehachse. Alternativ ist es möglich, bei einem ersten Beleuchtungssetting die Pupille mit einer ersten räumlichen Polarisationsverteilung, beispielsweise mit gleicher Polarisation über die gesamte Pupille, auszuleuchten und in einem zweiten Beleuchtungssetting Teile der Pupille mit einer ersten Polarisationsrichtung des Beleuchtungslichts und andere Teile der Pupille mit einer weiteren Polarisationsrichtung des Beleuchtungslichts auszuleuchten. In diesem Fall wird nicht nur die Polarisationsrichtung, sondern auch die Polarisationsverteilung in der Pupille geändert. Im Sinne der vorliegenden Anmeldung sind Beleuchtungssettings dann unterschiedlich, wenn sich ihre Intensitätsverteilung als skalare Größe und/oder ihre Polarisationsverteilung als vektorielle Größe über die Pupille unterscheidet. Die unterschiedlichen Polarisationszustände lassen sich anhand von vektoriellen E-Feld-Vektoren des Beleuchtungslichts als vektorielle Größen in der Pupille beschreiben. Hierbei kann die Pupille auch eine nicht ebene, also gekrümmte Fläche sein. Die Intensitätsverteilung wird dann als skalare Größe und die Polarisationsverteilung wird dann als vektorielle Größe über diese gekrümmte Fläche beschrieben.

Eine Beleuchtungsoptik mit sich lediglich im Polarisationszustand, also beispielsweise im Polarisationstyp (linear, zirkular) und/oder in der Polarisationsrichtung und/oder in der räumlichen Polarisationsverteilung, unterscheidenden Beleuchtungssettings ermöglicht eine Anpassung des Polarisationszustandes an wechselnde, insbesondere durch die Geometrie der abzubildenden Strukturen bedingte, Anforderungen an die Abbildung.

Eine optische Verzögerungskomponente nach Anspruch 8 erlaubt eine definierte zeitliche Synchronisation des durch die erste optische Baugruppe geführten Beleuchtungslichts relativ zum durch die zweite optische Baugruppe geführten Beleuchtungslichts im Lichtweg nach dem Einkoppelelement. Dies kann genutzt werden, um eine Lichtdosis auf den optischen Komponenten ab dem Einkoppelelement zeitlich zu vergleichmäßigen, um somit insbesondere bei gepulsten Lichtquellen die Energiedeposition pro Puls in den optischen Komponenten zu reduzieren. Dies gilt insbesondere auch für die optischen Komponenten der Projektionsbelichtungsanlage, die in Strahlrichtung des Beleuchtungs- bzw. Projektionsstrahls nach dem Einkoppelelement angeordnet sind, wie zum Beispiel ein Kondensor, ein REMA- (Retikel/Masking-) Objektiv, ein Retikel bzw. eine Maske, optische Komponenten eines Projektionsobjektivs, Immersions-schichten bis hin zum Fotoresist, dem Wafer und dem Waferstage. Bei der optischen Verzögerungskomponente kann es sich um eine optische Verzögerungsstrecke handeln, die im Lichtweg der ersten optischen Baugruppe oder im Lichtweg der zweiten optischen Baugruppe angeordnet ist. Vorzugsweise ist die optische Verzögerung über die optische Verzögerungskomponente einstellbar, was beispielsweise über einen Linear-Verschiebetisch längs eines Weges, über den das Beleuchtungslicht vorzugsweise mehrfach geführt ist und einem mit dem Linear-Verschiebetisch fest verbundenen Spiegel, insbesondere einem retroreflektierenden Spiegel, realisiert werden kann. Alternativ und insbesondere zur Einstellung kleinerer Verzögerungswege kann die optische Verzögerungskomponente als optisch transparentes und optisch dichteres Medium mit vorgegebenem optischem Weg ausgeführt sein. Auch eine Kombination einer optischen Verzögerungskomponente, bei der die optische Verzögerung auf einer Vergrößerung des reinen Weges beruht, mit einer optischen Verzögerungskomponente, bei der die optische Verzögerung auf einem Lichtweg in einem optisch dichteren Medium beruht, kann zum Einsatz kommen.

Eine weitere Aufgabe der Erfindung ist es, ein Beleuchtungssystem für eine derartige Beleuchtungsoptik anzugeben, mit dem die Spitzenbelastung auf das Retikel sowie auf dem Auskoppel-Strahlteiler nachgelagerte optische Komponenten reduziert ist.

Diese Aufgabe ist erfindungsgemäß gelöst durch ein Beleuchtungssystem mit den im Anspruch 9 angegebenen Merkmalen.

Durch den Wechsel der Lichteigenschaft während des Beleuchtungs-Lichtimpulses wird dieser in zwei Lichtimpuls-Anteile aufgeteilt, die dann zu unterschiedlichen Beleuchtungssettings geformt werden. Die Komponentenbelastung, insbesondere die lokale Komponentenbelastung durch das Beleuchtungslicht, wird hierdurch vorteilhaft reduziert. Durch den Wechsel der Lichteigenschaft während des Beleuchtungs-Lichtimpulses kann bei Wahl eines Lasers als Lichtimpulsquelle mit einem Laser halber Repetitionsrate, doppelter Einzelimpuls-Energie und doppelter Impulsdauer gearbeitet werden. Die Einzelimpuls-Energie ist dabei das Integral der Leistung des einzelnen Pulses über dessen Impulsdauer. Derartige Laser stehen zur Verfügung bzw. lassen sich einfacher entwickeln und in eine MikroLithografie-Projektionsbelichtungsanlage integrieren als Laser mit höherer Repetitionsrate, die wesentlich kostenaufwändiger sind.

Ein Beleuchtungssystem nach Anspruch 10 reduziert die mittlere Lichtleistung auf den optischen Baugruppen, indem nicht alle Lichtimpulse der Lichtquelle durch die gleiche optische Baugruppe geleitet werden. Eine entsprechende Synchronisation vorausgesetzt, kann anstelle der Lichteigenschafts-Wechseleinrichtung nach Anspruch 10 auch ein Auskoppelelement nach Anspruch 6, ein Auskoppelelement mit einer Mehrzahl von Einzelspiegeln, die auf einem drehantreibbaren Spiegelträger angeordnet sind oder ein Auskoppelelement eingesetzt sein, das als bandförmige Spiegelfolie ausgebildet ist, die Einzelspiegel trägt, zwischen denen transparente Lücken ausgebildet sind. Im Fall des Einsatzes eines solchen Auskoppelelements wird z. B. jeder zweite Lichtimpuls vom Auskoppelelement durchgelassen und die jeweils dazwischen liegenden Lichtimpulse werden von den Spiegelelementen des Auskoppelelements hin zur anderen optischen Baugruppe reflektiert. Die Lichteigenschafts-Wechseleinrichtung kann z.B. so ausgeführt sein, dass die Lichteigenschaft zwischen zwei aufeinanderfolgenden Lichtimpulsen gewechselt wird.

Das Beleuchtungssystem kann mindestens zwei Lichtquellen zur Erzeugung von gepulstem Beleuchtungslicht aufweisen. Ein solches Beleuchtungssystem reduziert die Anforderungen an eine einzelne Lichtquelle. Das Beleuchtungslicht, welches von den mindestens zwei Lichtquellen erzeugt wird, wird mit einer optischen Zusammenführeinrichtung zu einem Beleuchtungs-Lichtstrahl zusammengeführt, der das Beleuchtungsfeld ausleuchtet. Zur Zusammenführung kann ein Strahlteiler nach Art des Einkoppel- oder Auskoppel-Strahlteilers genutzt werden; dies ist aber nicht zwingend. Alternativ ist es z. B. möglich, mindestens zwei Beleuchtungs-Lichtstrahlen der Lichtquellen über Einkoppelspiegel oder Einkoppellinsen zusammenzuführen.

Bei dem Beleuchtungssystem könnten die beiden Lichtquellen über den gleichen Auskoppel-Strahlteiler den beiden optischen Baugruppen zugeführt werden. Ein solches Beleuchtungssystem ist kompakt.

Die zentrale Steuereinrichtung des Beleuchtungssystems kann zusätzlich mit mindestens einer Komponente aus der nachfolgenden Gruppe in Signalverbindung stehen:
- die mindestens eine Lichtquelle,
- die beiden optischen Baugruppen,
- ein Retikel-Masking-System,
- ein Retikel-Stage,
- ein Wafer-Stage.
Eine solche Steuereinrichtung kann über ihre Signalanbindungen mit den Komponenten des Beleuchtungssystems Informationen zum jeweiligen Beleuchtungssetting gewinnen, kann bestimmte vorgegebene Beleuchtungssettings durch Eingriff in die Justage der optischen Baugruppen einstellen und zusätzliche Anpassungen, z. B. über das Retikel-Masking-System oder über die Scan-Geschwindigkeiten, vornehmen.

Eine weitere Aufgabe der Erfindung ist es, eine Mikrolithografie-Projektionsbelichtungsanlage mit einer erfindungsgemäßen Beleuchtungsoptik bzw. einem erfindungsgemäßen Beleuchtungssystem zu schaffen und ein hiermit durchführbares mikrolithografisches Herstellungsverfahren.

Diese Aufgabe ist erfindungsgemäß gelöst durch eine Mikrolithografie-Projektionsbelichtungsanlage nach Anspruch 11 und ein Herstellungsverfahren nach Anspruch 12.

Vorteile dieser Gegenstände ergeben sich aus den oben im Zusammenhang mit der Beleuchtungsoptik und dem Beleuchtungssystem angegebenen Vorteilen.

Eine weitere Aufgabe der Erfindung ist es schließlich, ein Ergänzungsmodul für eine Mikrolithografie-Projektionsbelichtungsanlage bereitzustellen, mit dem eine bereits bestehende Beleuchtungsoptik bzw. ein bereits bestehendes Beleuchtungssystem zur Nutzung der vorstehend diskutierten Vorteile nachgerüstet werden kann.

Diese Aufgabe ist erfindungsgemäß gelöst durch ein Ergänzungsmodul mit den im Anspruch 13 angegebenen Merkmalen und durch ein Ergänzungsmodul mit den im Anspruch 14 angegebenen Merkmalen.

Die Vorteile dieses Ergänzungsmoduls entsprechen den vorstehend in Bezug auf die Beleuchtungsoptik und das Beleuchtungssystem schon angegebenen Vorteilen.

Die einzelnen Komponenten des Ergänzungsmoduls, also die optische Ergänzungs-Baugruppe, das mindestens eine Auskoppelelement, das mindestens eine Einkoppelelement sowie die ggf. zusätzlich noch vorgesehene Lichteigenschafts-Wechseleinrichtung und eine ggf. zusätzlich bereitgestellte zentrale Steuereinrichtung können so ausgeführt bzw. weitergebildet sein, wie dies vorstehend in Bezug auf die erfindungsgemäße Beleuchtungsoptik oder das erfindungsgemäße Beleuchtungssystem bereits ausgeführt wurde. Das weitere Beleuchtungssetting, welches vom Ergänzungsmodul zur Verfügung gestellt wird, kann vom Beleuchtungssetting der ersten optischen Baugruppe verschieden sein. Bei bestimmten Anwendungen kann auch hier das weitere Beleuchtungssetting innerhalb vorgegebener Toleranzgrenzen in allen Lichteigenschaften mit dem Beleuchtungssetting der ersten optischen Baugruppe übereinstimmen. Hier gilt daher entsprechend, was vorstehend im Zusammenhang mit dem Beleuchtungssytem nach Anspruch 1 bzw. 17 ausgeführt wurde.

Ausführungsbeispiele der Erfindung werden nachfolgend anhand der Zeichnung näher erläutert. In dieser zeigen:
- Fig. 1: Eine schematische Übersicht einer Mikrolithografie-Projektionsbelichtungsanlage mit einem ersten Beleuchtungssystem;
- Fig. 2: schematisch zwei aufeinander folgende Lichtimpulse einer Lichtquelle der Projektionsbelichtungsanlage nach Fig. 1 mit einem ersten Schaltzeit-Beispiel einer Lichteigenschafts-Wechseleinrichtung;
- Fig. 3 und 4: in einer zu Fig. 2 ähnlichen Darstellung weitere Schaltzeit-Beispiele;
- Fig. 5: schematisch eine zur Fig. 1 ähnliche Übersicht einer Mikrolithografie-Projektionsbelichtungsanlage mit einer weiteren Ausführungsform eines Beleuchtungssystems;
- Fig. 6 bis 9: in einer zu Fig. 2 ähnlichen Darstellung Schaltzeit-Beispiele beim Einsatz des Beleuchtungssystems nach Fig. 5;
- Fig. 10: schematisch eine zur Fig. 1 ähnliche Übersicht einer Mikrolithografie-Projektionsbelichtungsanlage mit einer weiteren Ausführungsform eines Beleuchtungssystems;
- Fig. 11: die Mikrolithografie-Projektionsanlage nach Fig. 1 mit Steuerungskomponenten hierzu;
- Fig. 12 u. 13: schematisch eine zur Fig. 1 ähnliche Übersicht einer Mikrolithografie-Projektionsbelichtungsanlage mit einer weiteren Ausführungsform eines Beleuchtungssystems;
- Fig. 14: schematisch ein Auskoppel- bzw. Einkoppelelement zum Einsatz im Beleuchtungssystem nach Fig. 13;
- Fig. 15: schematisch eine weitere Ausführungsform eines Auskoppel- bzw. Einkoppelelements zum Einsatz im Beleuchtungssystem nach Fig. 13;
- Fig. 16: schematisch eine Polarisations-Wechseleinrichtung, welches insbesondere im Beleuchtungssystem nach Fig. 1 anstelle einer Pockelszelle zum Einsatz kommen kann;
- Fig. 17: schematisch eine zur Figur 1 ähnliche Übersicht einer Mikrolithografie-Projektionsbelichtungsanlage mit einer weiteren Ausführungsform eines Beleuchtungssystems mit einer optischen Verzögerungskomponente;
- Fig. 18: ein mit einer optischen Baugruppe eines Beleuchtungssystems einer der Ausführungsformen eingestelltes Beleuchtungssetting in einer Aufsicht auf eine Pupillenebene des Beleuchtungssystems;
- Fig. 19: in einer zu Figur 18 ähnlichen Ansicht eine Variante eines mit einer der optischen Baugruppen einstellbaren Beleuchtungssettings;
- Fig. 20: stark vergrößert eine mit einem Beleuchtungssystem einer der Ausführungsformen abbildbare Maskenstruktur mit dichten vertikalen Linien;
- Fig. 21: in einer zur Figur 20 ähnlichen Darstellung eine Maskenstruktur mit isolierten Linien;
- Fig. 22: in einer zur Figur 18 ähnlichen Darstellung ein weiteres mit den optischen Baugruppen einstellbares Beleuchtungssetting;
- Fig. 23: in einer zur Figur 18 ähnlichen Darstellung ein weiteres mit den optischen Baugruppen einstellbares Beleuchtungssetting;
- Fig. 24: in einer zur Figur 20 ähnlichen Darstellung eine Variante einer Maskenstruktur, die mit einem Beleuchtungssetting nach den Figuren 22 oder 23 beleuchtet wird;
- Fig. 25: in einer zur Figur 20 ähnlichen Darstellung eine Variante einer Maskenstruktur, die mit einem Beleuchtungssetting nach den Figuren 22 oder 23 beleuchtet wird;
- Fig. 26: in einer zur Figur 18 ähnlichen Darstellung ein weiteres mit den optischen Baugruppen einstellbares Beleuchtungssetting;
- Fig. 27: in einer zur Figur 18 ähnlichen Darstellung ein weiteres mit den optischen Baugruppen einstellbares Beleuchtungssetting;
- Fig. 28: in einer zur Figur 20 ähnlichen Darstellung eine Variante einer Maskenstruktur, die mit einem Beleuchtungssetting nach Figur 26 beleuchtet wird; und
- Fig. 29: in einer zur Figur 20 ähnlichen Darstellung eine Variante einer Maskenstruktur, die mit einem Beleuchtungssetting nach Figur 27 beleuchtet wird.

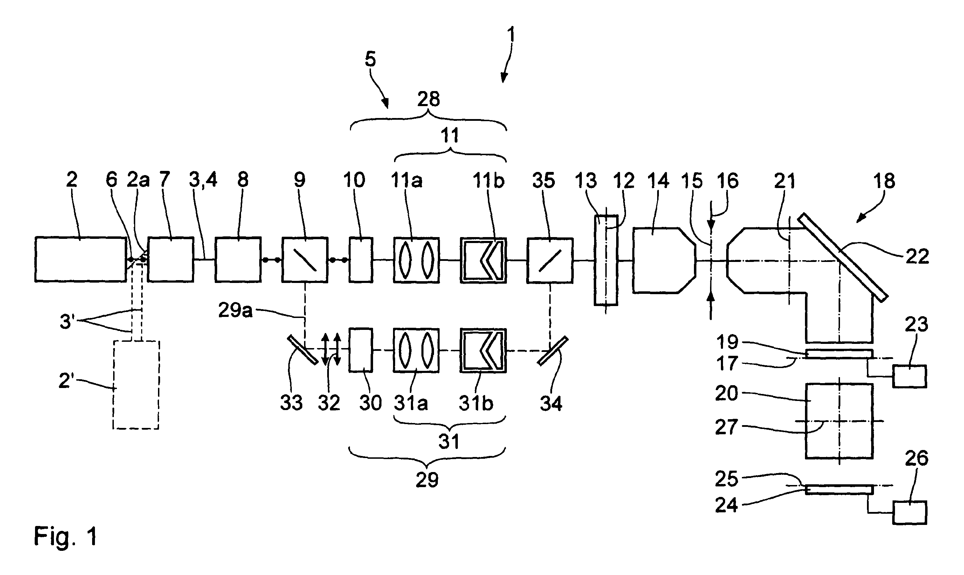

In Fig. 1 ist eine Mikrolithografie-Projektionsbelichtungsanlage 1 gezeigt, die bei der Herstellung von Halbleiterbauelementen und anderen fein strukturierten Bauelementen einsetzbar ist und zur Erzielung von Auflösungen bis zu Bruchteilen von Mikrometern mit Licht aus dem Vakuum-Ultraviolettbereich (VUV) arbeitet. Als Lichtquelle 2 dient ein ArF-Excimer-Laser mit einer Arbeitswellenlänge von 193 nm, dessen linear polarisierter Lichtstrahl 3 koaxial zu einer optischen Achse 4 eines Beleuchtungssystems 5 der Projektionsbelichtungsanlage 1 ausgerichtet ist. Andere UV-Lichtquellen, beispielsweise F₂-Lasern mit 157 nm Arbeitswellenlänge, ArF-Laser mit 248 nm Arbeitswellenlänge oder Quecksilberdampflampen mit 368 nm oder 436 nm Arbeitswellenlänge sowie Lichtquellen mit Wellenlängen unterhalb 157 nm sind ebenfalls möglich.

Das Licht der Lichtquelle 2 ist nach dem Austritt aus dieser zunächst senkrecht zur Zeichenebene der Fig. 1 polarisiert (s-Polarisation). Dies ist in der Fig. 1 durch einzelne Punkte 6 auf dem Lichtstrahl 3 angedeutet. Dieses linear polarisierte Licht der Lichtquelle 1 tritt zunächst in einen Strahlaufweiter 7 ein, der beispielsweise als Spiegelanordnung gemäß der DE 41 24 311 ausgebildet sein kann und zur Kohärenzreduktion und Vergrößerung des Strahlquerschnitts dient. Nach dem Strahlaufweiter 7 durchtritt der Lichtstrahl 3 eine Pockelszelle 8 als Beispiel für eine Lichteigenschafts-Wechseleinrichtung. Solange an der Pockelszelle 8 keine Spannung anliegt, ist der die Pockelszelle 8 verlassene Lichtstrahl 3 ebenfalls s-polarisiert. Anschließend durchtritt der Lichtstrahl 3 einen Auskoppel-Strahlteiler 9 als Beispiel für ein Auskoppelelement, der als Polarisationswürfel aus CaF₂ oder Quarz ausgebildet ist. Der s-polarisierte Lichtstrahl 3 wird vom Auskoppel-Strahlteiler 9 in Richtung der optischen Achse 4 durchgelassen und durchtritt ein erstes diffraktives optisches Rasterelement (DOE) 10. Das erste DOE 10 dient als Strahlformungselement und ist in einer Eintrittsebene einer im Strahlengang dahinter angeordneten ersten Objektivgruppe 11 angeordnet.

Die erste Objektivgruppe 11 umfasst ein Zoom-System 11a und eine nachfolgende Axiconanordnung 11b. Das Zoom-System 11a ist beidseitig telezentrisch und ist als Maßstabs-Zoom ausgelegt, so dass zwischen einer Eintrittsebene und einer Austrittsebene des Zoom-Systems 11 a eine optische Abbildung mit vorgegebener Vergrößerung erreicht wird. Das Zoom-System 11 a kann zudem die Funktion eines Brennweiten-Zooms haben, so dass zwischen der Eintrittsebene und der Austrittsebene des Zoom-Systems 11a auch zum Beispiel eine dreifache Fourier-Transformation auftritt. Die nach dem Zoom-System 11a eingestellte Beleuchtungslichtverteilung erfährt durch die gegeneinander axial verschiebbaren Axiconelemente der Axiconanordnung 11b eine radiale Umverteilung, sofern ein endlicher Abstand zwischen den einander zugewandten konischen Axiconflächen der Axiconelemente eingestellt ist. Wird dieser Abstand auf Null reduziert, so wirkt die Axiconanordnung 11b im Wesentlichen als planparallele Platte und beeinflusst die durch das Zoom-System 11a erzeugte Ortsverteilung der Beleuchtung praktisch nicht. Die optischen Komponenten des Zoom-Systems 11a und der Axiconanordnung 11b können in ihrem axialen Abstand zueinander durch nicht dargestellte Aktuatoren eingestellt werden.

Die erste Objektivgruppe 11 ist Teil einer Pupillenformungseinheit, mit der in einer hinter der Objektivgruppe 11 liegenden Pupillenformungsebene 12 des Beleuchtungssystems 5 eine definierte, örtliche zweidimensionale Beleuchtungsintensitätsverteilung des Beleuchtungslichts der Lichtquelle 2, die sogenannte Beleuchtungspupille bzw. das Beleuchtungssetting, eingestellt wird.

Die Pupillenformungsebene 12, die eine Pupillenebene des Beleuchtungssystems 5 ist, fällt mit der Austrittsebene der ersten Objektivgruppe 11 zusammen. In unmittelbarer Nähe der Austrittsebene 12 ist ein weiteres optisches Rasterelement 13 angeordnet. Eine dahinter angeordnete Einkoppeloptik 14 überträgt das Beleuchtungslicht auf eine Zwischenfeldebene 15, in der ein Retikel-Masking-System (REMA) 16 angeordnet ist, welches als verstellbare Feldblende dient. Das optische Rasterelement 13 hat eine zweidimensionale Anordnung difraktiver oder refraktiver optischer Elemente und hat mehrere Funktionen. Einerseits wird durch das optische Rasterelement 13 das eintretende Beleuchtungslicht so geformt, dass es nach Durchtritt durch die nachfolgende Einkoppeloptik 14 im Bereich der Feldebene 15 ein rechteckförmiges Beleuchtungsfeld ausleuchtet. Das auch als Feld-definierendes Element (FDE) bezeichnete optische Rasterelement 13 mit rechteckiger Abstrahlcharakteristik erzeugt dabei den Hauptanteil des Lichtleitwertes und adaptiert diesen an die gewünschte Feldgröße und Feldform in der Feldebene 15, die zu einer Maskenebene 17 konjugiert ist. Das optische Rasterelement 13 kann als Prismen-Array ausgeführt sein, bei dem in einem zweidimensionalen Feld angeordnete Einzelprismen lokal bestimmte Winkel einführen, um die Feldebene 15 - wie gewünscht - auszuleuchten. Die durch die Einkoppeloptik 14 bewirkte Fourier-Transformation bewirkt, dass jeder spezifische Winkel am Austritt des optischen Rasterelements 13 einem Ort in der Feldebene 15 entspricht, während der Ort des optischen Rasterelements 13, d. h. seine Position in Bezug auf die optische Achse 4, den Beleuchtungswinkel in der Feldebene 15 bestimmt. Die von den einzelnen optischen Elementen des optischen Rasterelements 13 ausgehenden Strahlenbündel überlagern sich dabei in der Feldebene 15. Es ist auch möglich, dass FDE 13 nach Art eines mehrstufigen Wabenkondensors mit Mikrozylinderlinsen und Streuscheiben auszugestalten. Durch geeignete Auslegung des FDE 13 bzw. seiner einzelnen optischen Elemente kann erreicht werden, dass das Rechteckfeld in der Feldebene 15 im Wesentlichen homogen ausgeleuchtet wird. Das FDE 13 dient somit als Feldformungs- und Homogenisierungselement auch der Homogenisierung der Feldausleuchtung, so dass auf ein gesondertes Lichtmischelement, beispielsweise einen über mehrfache innere Reflexion wirkenden Integratorstab oder einen Wabenkondensor verzichtet werden kann. Der optische Aufbau wird in diesem Bereich hierdurch axial besonders kompakt.

Ein nachfolgendes Abbildungsobjektiv 18, das auch REMA-Objektiv genannt wird, bildet die Zwischenfeldebene 15 mit dem REMA 16 auf ein Retikel bzw. dessen Oberfläche 19 in der Maskenebene 17 in einem Maßstab ab, der zum Beispiel zwischen 2:1 und 1:5 liegen kann und bei der in der Fig. 1 dargestellten Ausführungsform etwa bei 1:1 1 liegt. Die Abbildung erfolgt ohne Zwischenbild, so dass zwischen der Zwischenfeldebene 15, die einer Objektebene des Abbildungsobjektivs 18 entspricht, und einer mit der Maskenebene 17 zusammenfallenden Bildebene des Abbildungsobjektivs 18, die der Austrittsebene des Beleuchtungssystems und gleichzeitig einer Objektebene eines nachfolgendes Projektionsobjektivs 20 entspricht, genau eine Pupillenebene 21 liegt. Letztere ist eine Fourier-transformierte Ebene zur Austrittsebene 17 des Beleuchtungssystems 5. Ein zwischen der Pupillenebene 21 und der Maskenebene 17 angeordneter, um 45° zur optischen Achse 4 geneigter Umlenkspiegel 22 ermöglicht es, das relativ große Beleuchtungssystem 5, das mehrere Meter lang ist, horizontal einzubauen und gleichzeitig das Retikel 19 waagrecht zu lagern.

Diejenigen optischen Komponenten, die das Beleuchtungslicht der Lichtquelle 2 führen und hieraus Beleuchtungslicht formen, welches auf das Retikel 19 gerichtet ist, gehören zum Beleuchtungssystem 5 der Projektionsbelichtungsanlage. Hinter dem Beleuchtungssystem 5 ist eine Einrichtung 23 zum Halten und Manipulieren des Retikels 19 so angeordnet, dass ein auf dem Retikel angeordnetes Muster in der Objektebene 17 des Projektionsobjektivs 20 liegt und in dieser Ebene zum Scannerbetrieb in einer Scan-Richtung senkrecht zur optischen Achse 4 mithilfe eines Scanantriebs bewegbar ist.

Das Projektionsobjektiv 20 dient als Reduktionsobjektiv und bildet ein Bild des Retikels 19 in reduziertem Maßstab, beispielsweise im Maßstab 1:4 oder 1:5, auf einen mit einer Fotoresistschicht bzw. Fotolackschicht belegten Wafer 24 ab, dessen lichtempfindliche Oberfläche in einer Bildebene 25 des Projektionsobjektivs 20 liegt. Es sind refraktive, katadioptrische oder katoptrische Projektionsobjektive möglich. Andere Reduktionsmaßstäbe, beispielsweise auch stärkere Verkleinerungen bis 1:20 oder 1:200, sind möglich.

Der zu belichtende Halbleiterwafer 24 wird durch eine Einrichtung 26 zum Halten und Manipulieren gehalten, die einen Scannerantrieb umfasst, um den Wafer 24 synchron mit dem Retikel 19 senkrecht zur optischen Achse 4 zu bewegen. Je nach Auslegung des Projektionsobjektivs 20 können diese Bewegungen zueinander parallel oder gegenparallel erfolgen. Die Einrichtung 26, die auch als Waferstage bezeichnet wird, sowie die Einrichtung 23, die auch als Retikelstage bezeichnet wird, sind Bestandteile einer Scannereinrichtung, die über eine Scan-Steuereinrichtung gesteuert wird.

Die Pupillenformungsebene 12 liegt an oder nahe einer Position, die optisch konjugiert zur nächsten nachfolgenden Pupillenebene 21 sowie zu einer bildseitigen Pupillenebene 27 des Projektionsobjektivs 20 ist. Somit wird die räumliche bzw. örtliche Lichtverteilung in der Pupillenebene 27 des Projektionsobjektivs 20 durch die räumliche Licht- bzw. Ortsverteilung in der Pupillenformungsebene 12 des Beleuchtungssystems 5 bestimmt. Zwischen den Pupillenflächen 12, 21 und 27 liegen jeweils Feldflächen im optischen Strahlengang, die Fourier-transformierte Flächen zu den jeweiligen Pupillenflächen sind. Dies bedeutet, dass eine definierte Ortsverteilung von Beleuchtungsintensität in der Pupillenformungsebene 12 eine bestimmte Winkelverteilung des Beleuchtungslichts im Bereich der nachfolgenden Feldebene 15 ergibt, die wiederum einer bestimmten Winkelverteilung des auf das Retikel 19 fallenden Beleuchtungslichts entspricht. Die erste Objektivgruppe 11 bildet zusammen mit dem ersten DOE 10 eine erste optische Baugruppe 28 zur Einstellung eines ersten Beleuchtungssettings in der Beleuchtungspupille 12.

Eine Besonderheit des Beleuchtungssystems 5 besteht darin, dass eine sehr schnelle Veränderung der Beleuchtungspupille 12 während eines Beleuchtungsvorgangs für ein einzelnes Retikel 19 möglich ist. Dadurch sind Doppelbelichtungen oder andere Mehrfachbelichtungen in kurzen Zeitintervallen möglich.

Zur schnellen Veränderung der Beleuchtungssettings in der Pupillenformungsebene 12 dient eine zweite optische Baugruppe 29, die in einem Auskoppelast 29a des Auskoppel-Strahlteilers 9 angeordnet ist. Die zweite optische Baugruppe 29 umfasst ein zweites DOE 30 und eine zweite Objektivbaugruppe 31, die wiederum in ein Zoom-System 31a und eine Axiconanordnung 31b unterteilt ist. Im Aufbau entsprechen sich die beiden optischen Baugruppen 28, 29. Die optische Wirkung und die Anordnung der einzelnen optischen Komponenten des Zoom-Systems 31a und der Axiconanordnung 31b sowie des zweiten DOE 30 sind allerdings so von der ersten optischen Baugruppe 28 verschieden, dass Beleuchtungslicht der Lichtquelle 2, welches die zweite optische Baugruppe 29 durchtritt, so beeinflusst wird, dass in der Pupillenformungsebene 12 ein zweites Beleuchtungssetting entsteht, welches sich vom ersten Beleuchtungssetting, welches durch die erste optische Baugruppe 28 erzeugt wird, unterscheidet.

Der Auskoppelast 29a ist in der Fig. 1 gestrichelt angedeutet. Im Auskoppelast 29a wird Beleuchtungslicht zur Zeichenebene der Fig. 1 parallelen Polarisationsrichtung (p-Polarisation) geführt, was in der Fig. 1 durch zur optischen Achse im Auskoppelast 29a senkrechte Doppelpfeile 32 angedeutet ist.

Zwischen dem Auskoppel-Strahlteiler 9 und dem zweiten DOE 30 ist ein Umlenkspiegel 33 nach Art des Umlenkspiegels 22 angeordnet. Ein weiterer Umlenkspiegel 34 ist zwischen der Axiconanordnung 31b der zweiten Objektivgruppe 31 und einem Einkoppel-Strahlteiler 35 angeordnet, der wie der Auskoppel-Strahlteiler 9 als Polarisationswürfel aufgebaut ist. Der Einkoppel-Strahlteiler 35 stellt ein Beispiel für ein Einkoppelelement dar. Der Einkoppel-Strahlteiler 35 ist im Lichtweg zwischen der Axiconanordnung 11b der ersten Objektivebene 11 und dem optischen Rasterelement 13 angeordnet. Beleuchtungslicht, welches auf dem Auskoppelast 29a geführt wurde, wird vom Einkoppel-Strahlteiler 35 so umgelenkt, dass es nach diesem exakt auf der optischen Achse 4 verläuft.

Zur schnellen Änderung des Beleuchtungssettings wird an die Pockelszelle 8 Hochspannung von typisch 5 bis 10 kV angelegt. Innerhalb weniger einzelner Nanosekunden erfolgt bei angelegter Hochspannung in der Pockelszelle 8 eine Polarisationsdrehung des Beleuchtungslichts von s-Polarisation auf p-Polarisation. Das p-polarisierte Beleuchtungslicht wird in den Auskoppelast 29a ausgekoppelt, da ein Polarisator im Auskoppel-Strahlteiler 9 für die p-Polarisation als Reflektor wirkt. Im Auskoppelast 29a erfährt das Beleuchtungslicht eine andere Settingeinstellung als das nicht ausgekoppelte s-polarisierte Beleuchtungslicht. Das p-polarisierte Beleuchtungslicht, welches die zweite optische Baugruppe 29 passiert hat, wird nach Umlenkung durch den Umlenkspiegel 34 über den EinkoppelStrahlteiler 35, dessen Polarisator für das p-polarisierte Licht wie ein Reflektor wirkt, wieder in Richtung der optischen Achse 4 eingekoppelt.

Die Lichtquelle 2 erzeugt beispielsweise Laserimpulse einer Länge von 100 oder 150 ns und einer Einzelimpulsenergie von 15 oder 30 mJ bei einer Repetitionsrate von 6 kHz.

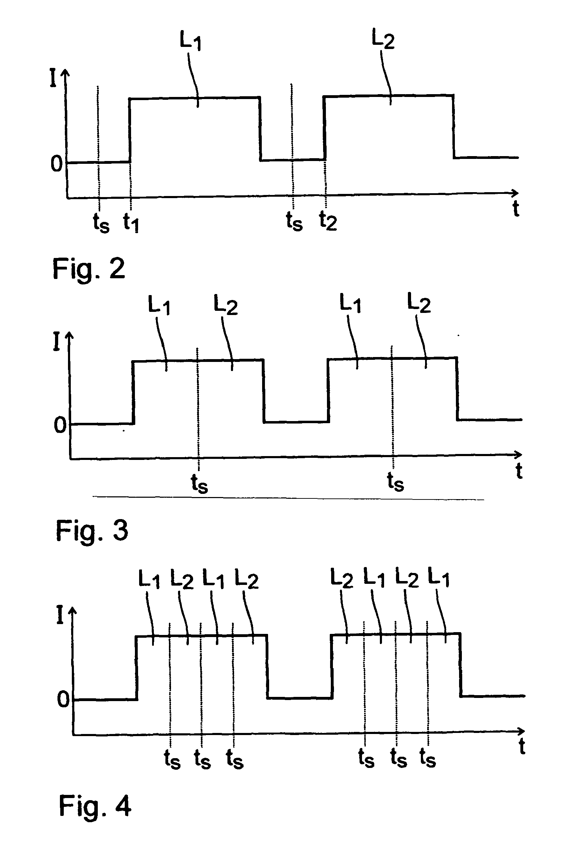

Fig. 2 bis 4 zeigen verschiedene Schaltzeit-Beispiele für Hochspannungs-Schaltzeitpunkte tₛ der Pockelszelle 8. Den Fig. 2 bis 4 gemeinsam ist die schematische, rechteckige Darstellung von Einzelimpulsen L der Lichtquelle 2, die in einem zeitlichen Abstand t_{z} = t₂ - t₁ aufeinander folgen, der dem Kehrwert der Repetitionsrate von 6 kHz entspricht. Beim Schaltzeit-Beispiel nach Fig. 2 wird jeweils zwischen zwei Laserimpulsen L die Pockelszelle 8 geschaltet. Der in der Fig. 2 links dargestellte Laserimpuls L₁ passiert die Pockelszelle, ohne dass eine Spannung angelegt ist, bleibt also s-polarisiert. Der darauf folgende Laserimpuls L₂ wird, da zwischenzeitlich der Schaltzeitpunkt tₛ eingetreten ist, in seiner Polarisation um 90° gedreht, durchläuft also den Auskoppelast 29a. Der wiederum folgende, nicht dargestellte Laserimpuls durchtritt die Pockelszelle 8 ohne Polarisationsbeeinflussung. Jeder zweite Laserimpuls wird beim Schaltzeit-Beispiel nach Fig. 2 also durch den Auskoppelast 29a geführt, während die anderen Laserimpulse nicht ausgekoppelt werden. Das Retikel 19 erfährt also eine wechselweise Beleuchtung mit zwei entsprechend der Einstellung der optischen Baugruppen 28, 29 unterschiedlichen Beleuchtungssettings, wobei zu jedem Beleuchtungssetting Laserimpulse mit einer Repetitionsrate von 3 kHz beitragen. Die das Retikel und die optischen Komponenten des Beleuchtungssystems nach dem Auskoppel-Strahlteiler 9 treffende Strahlungsbelastung wird durch die Energie und die Spitzenintensität eines einzelnen Laserimpulses L vorgegeben.

Beim Schaltzeit-Beispiel nach Fig. 3 schaltet die Pockelszelle 8, während sie von einem einzelnen Laserimpuls L durchlaufen wird. Der einzelne Laserimpuls L wird also unterteilt. Im Beispiel nach Fig. 3 ist der führende Laserimpuls-Anteil L₁ in seiner Polarisation unbeeinflusst, bleibt also s-polarisiert. Der folgende Laserimpuls-Anteil L₂ erfährt hingegen, da er die Pockelszelle 8 nach dem Schaltzeitpunkt tₛ durchläuft, eine Polarisationsdrehung, wird ausgekoppelt und erzeugt ein anderes Beleuchtungssetting als der Laserimpuls-Anteil L₁. Die beiden Laserimpuls-Anteile L₁ und L₂ haben eine Impulsdauer, die in etwa der Hälfte der Impulsdauer des ungeteilten Laserimpulses entspricht und die beim Ausführungsbeispiel also bei 50 oder 75 ns liegt. Die Energie der Laserimpuls-Anteile beträgt in etwa die halbe Energie der einzelnen Laserimpulse, also 7,5 oder 15 mJ. Der in Fig. 3 zeitlich nachfolgende Laserimpuls ist im führenden Laserimpuls-Anteil L₂ zunächst in seiner Polarisation gedreht, hat also p-Polarisation. Zum Schaltzeitpunkt tₛ wird die Spannung der Pockelszelle 8 abgeschaltet, so dass der nachfolgende Laserimpuls-Anteil L₁ in seiner Polarisation nicht mehr beeinflusst wird, also s-polarisiert bleibt. Auch dieser zweite Laserimpuls wird also geteilt. Entsprechend wiederholt sich das Schalten während der Laserimpulse für die nicht dargestellten nachfolgenden Laserimpulse der Lichtquelle 2. Beim Schaltzeit-Beispiel nach Fig. 3 wird also jeweils ein Laserimpuls-Anteil durch den Auskoppelast 29a geführt, also durch die optische Baugruppe 29, und der andere Laserimpuls-Anteil durch die andere optische Baugruppe 28. Bei diesem Schaltzeit-Beispiel wird das Retikel 19 mit einer effektiven Repetitionsrate von 6 kHz mit einem ersten und mit der gleichen effektiven Repetitionsrate von 6 kHz mit dem zweiten Beleuchtungssetting beaufschlagt. Aufgrund der Halbierung der Einzelimpulsenergie in den Laserimpuls-Anteilen sinkt entsprechend die Spitzenbelastung des Retikels und der optischen Komponente nach dem Auskoppel-Strahlteiler 9 um etwa einen Faktor 2. Dieser Reduktionsfaktor ist in der Praxis noch höher, da die beiden durch die optischen Baugruppen 28, 29 erzeugten unterschiedlichen Beleuchtungssettings im Allgemeinen unterschiedliche Bereiche der Pupille mit unterschiedlichen Polarisationseigenschaften beanspruchen.

Beim Schaltzeit-Beispiel nach Fig. 4 wird jeweils in einem Laserimpuls L die Pockelszelle 8 dreimal geschalten. Beim in der Fig. 4 führenden, links dargestellten Laserimpuls L wird an der Pockelszelle zunächst Hochspannung angelegt, dann wieder abgeschalten und nochmals angelegt. Der in der Fig. 4 linke Laserimpuls L wird also unterteilt in einen führenden Laserimpuls-Anteil L₁ mit s-Polarisation, einen nachfolgenden Laserimpuls-Anteil L₂ mit p-Polarisation, einem wiederum nachfolgenden Laserimpuls-Anteil L₁ mit s-Polarisation und einen abschließenden Laserimpuls-Anteil L₂ mit p-Polarisation. Beim in der Fig. 4 rechts dargestellten Laserimpuls L sind die Verhältnisse genau umgekehrt, da beim ersten Schalten der Pockelszelle 8 während dieses in der Fig. 4 rechts dargestellten Laserimpulses L die Hochspannung zunächst abgeschalten wird. Der in der Fig. 4 rechts dargestellte Laserimpuls L weist also einen führenden p-polarisierten Laserimpuls-Anteil L₂, einen nachfolgenden s-polarisierten Laserimpuls-Anteil L₁, einen nachfolgenden p-polarisierten Laserimpuls-Anteil L₂ und einen abschließenden s-polarisierten Laserimpuls-Anteil L₁ auf. Das Retikel 19 wird beim Schaltzeit-Beispiel nach Fig. 4 jeweils mit einer effektiven Repetitionsrate von 12 kHz mit Beleuchtungslicht der beiden Beleuchtungssettings beaufschlagt. Die Lichtimpuls-Anteile L₁, L₂ haben beim Schaltzeit-Beispiel nach Fig. 4 eine Impulsdauer von etwa 25 oder 37,5 ns und eine Einzelimpulsenergie von etwa 3,75 oder 7,5 mJ. Da die einzelnen Lichtimpulse durch das dreimalige Schalten der Pockelszelle 8 während eines Lichtimpulses L geviertelt werden, sinkt entsprechend die Spitzenbelastung für das Retikel 19 sowie für die optischen Komponenten nach dem Auskoppel-Strahlteiler 9 um einen Faktor 4.

Die Lebensdauer optischen Materials hängt je nach Polarisationszustand nicht nur von einer Spitzen-Beleuchtungslichtenergie H, sondern auch von einer Impulszahl N und einer Impulsdauer T der Laserimpulse ab. Hierzu wurden verschiedene theoretische Modelle entwickelt, die dem Fachmann vertraut sind. Eines dieser Modelle ist das Polarisations-Doppelbrechungsmodell, wonach der Belastungsgrenzwert für optisches Material vom Produkt H x N abhängt. Beim sogenannten Compaction-Modell oder beim Mikrochannel-Modell hängt die Belastungsgrenze ab vom Produkt H² x N/T.

Eine einfache Vergleichsrechnung hierzu zeigt, dass durch eine einmalige Umschaltung durch die Pockelszelle 8 während eines Laserimpulses für die Doppelbelichtung der Einsatz eines Lasers 2 mit halber Repetitionsrate (Pulszahl N/2), doppelter Impuls-Laserenergie (2H) und doppelter Impulsdauer (2T) möglich ist. Solche Laser mit halber Repetitionsrate und doppelter Energie stellen eine Möglichkeit zur Leistungserhöhung aktueller Lithografielaser dar, die sich einfach realisieren lässt. Durch den Einsatz der Lichteigenschafts-Wechseleinrichtung 8 kann also nun ein 6 kHz-Laser in Mikrolithografie-Anwendungen eingesetzt werden, die bisher einem 12 kHz-Laser vorbehalten waren. Entsprechend sinken die baulichen Anforderungen an die Laserlichtquelle.

Zur Polarisationsbeeinflussung des Beleuchtungslichts kann anstelle der Pockelszelle 8 auch eine andere polarisationsbeeinflussende Lichteigenschafts-Wechseleinrichtung eingesetzt sein, zum Beispiel eine Kerr-Zelle.

Anstelle der Polarisation kann auch eine andere Eigenschaft des Beleuchtungslichts durch die Lichteigenschafts-Wechseleinrichtung beeinflusst werden, zum Beispiel die Lichtwellenlänge. In diesem Fall sind als Auskoppel-Strahlteiler 9 und als Einkoppel-Strahlteiler 35 dichroitische Strahlteiler eingesetzt.

Auch die Bündelgeometrie des Lichtstrahls 3 oder seine Richtung können Lichteigenschaften sein, die durch eine entsprechende Lichteigenschafts-Wechseleinrichtung zum Schalten zwischen den beiden optischen Baugruppen 28, 29 verändert werden. Als entsprechende Lichteigenschafts-Wechseleinrichtungen können eine Kerr-Zelle oder auch ein akustooptischer Modulator eingesetzt werden.

Vorstehend wurde ein Ausführungsbeispiel mit zwei optischen Baugruppen 28, 29 beschrieben. Genau so ist es möglich, mehr als zwei optische Baugruppen vorzusehen, zwischen denen gewechselt wird. So kann zum Beispiel zwischen dem Auskoppel-Strahlteiler 9 und dem DOE 10 oder im Auskoppelast 29a eine weitere Pockelszelle vorgesehen sein, die die Polarisation des Beleuchtungslichts zu vorgegebenen Schaltzeiten dreht und hierdurch eine Auskopplung in einen weiteren, in der Fig. 1 nicht dargestellten Auskoppelast bewirkt. Auf diese Weise lassen sich auch schnelle Wechsel zwischen mehr als zwei Beleuchtungssettings realisieren.

Die Pockelszelle 8 kann auch direkt in der Lichtquelle 2 angeordnet sein und die in der Lichtquelle 2 erzeugten Laserimpulse in mehrere Lichtimpuls-Anteile nach Art der Anteile L₁, L₂ zerhacken. Dies führt insbesondere zu einer Reduktion bzw. Zerstörung der Laserkohärenz, was störende Interferenzen in der Maskenebene 17 verhindert.

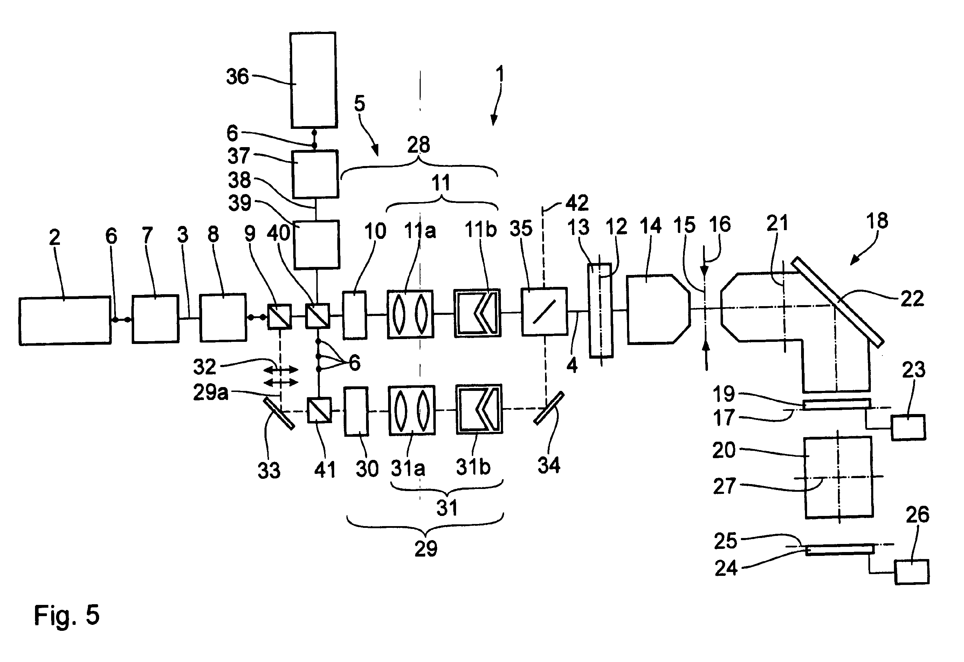

Fig. 5 zeigt eine weitere Ausführung eines erfindungsgemäßen Beleuchtungssystems. Komponenten, die denjenigen entsprechen, die vorstehend schon unter Bezugnahme auf die Fig. 1 bis 4 erläutert wurden, tragen die gleichen Bezugsziffern und werden nicht nochmals im Einzelnen diskutiert. Das Beleuchtungssystem nach Fig. 5 kann in Kombination mit sämtlichen Ausgestaltungsvarianten realisiert sein, die vorstehend schon unter Bezugnahme auf die Ausführung nach den Fig. 1 bis 4 erläutert wurden.

Zusätzlich zur Lichtquelle 2 hat das Beleuchtungssystem 5 nach Fig. 5 eine weitere Lichtquelle 36, deren interner Aufbau demjenigen der Lichtquelle 2 entspricht. Der Lichtquelle 36 nachgeordnet ist ein Strahlaufweiter 37, dessen Aufbau dem des Strahlaufweiters 7 entspricht. Ein Lichtstrahl 38 der Lichtquelle 36 wird vom Strahlaufweiter 37 aufgeweitet, wie dies im Zusammenhang mit dem Lichtstrahl 3 der Lichtquelle 2 schon beschrieben wurde. Dem Strahlaufweiter 37 nachgeordnet ist eine weitere Pockelszelle 39. Auch der Lichtstrahl 38 ist nach Verlassen der weiteren Lichtquelle 36 zunächst s-polarisiert, wie durch Punkte 6 auf dem Lichtstrahl 38 angedeutet. Solange an der Pockelszelle 39 keine Spannung anliegt, bleibt die Polarisation des Lichtstrahls 38 nach Durchgang durch die Pockelszelle 39 s-polarisiert. Nach der Pockelszelle 39 erreicht der Lichtstrahl 38 einen zweiten Auskoppel-Strahlteiler 40. Letzterer lässt s-polarisiertes Licht durch und reflektiert p-polarisiertes Licht um 90° in Fig. 5 nach rechts. In Durchlassrichtung des zweiten Auskoppel-Strahlteilers 40 diesem nachgeordnet ist ein polarisationsselektives Umlenkelement 41. Letzteres ist für s-polarisiertes Licht, welches aus Richtung des zweiten Auskoppel-Strahlteilers 40 einfällt, in Fig. 5 um 90° nach rechts reflektierend und lässt p-polarisiertes Licht ungehindert durch.

Mit dem Beleuchtungssystem 5 nach Fig. 5 lässt sich das Licht der beiden Lichtquellen 2 und 36 wahlweise in die beiden optischen Baugruppen 28, 29 einkoppeln.

Wenn an beiden Pockelszellen 8, 39 keine Spannung anliegt, beaufschlagt die Lichtquelle 2 die erste optische Baugruppe 28, da der s-polarisierte Strahl 3 von den beiden Auskoppel-Strahlteilern 9, 40 ungehindert durchgelassen wird. Solange keine Spannung an den beiden Pockelszellen 8, 39 anliegt, beaufschlagt die zweite Lichtquelle 36 die zweite optische Baugruppe 29, da der zweite Auskoppel-Strahlteiler 40 das s-polarisierte Licht des Lichtstrahls 38 ungehindert durchlässt und dieses s-polarisierte Licht vom Umlenkelement 41 in die zweite optische Baugruppe 29 gelenkt wird.

Wenn an der ersten Pockelszelle 8 Spannung anliegt und an der zweiten Pockelszelle 39 nicht, beaufschlagen beide Lichtquellen 2, 36 die zweite optische Baugruppe 29. Das nun p-polarisierte Licht der ersten Lichtquelle 2 wird vom Auskoppel-Strahlteiler 9, wie oben beschrieben, in den Auskoppelast 29a ausgekoppelt und durchtritt, nach Umlenkung durch den Umlenkspiegel 33, das Umlenkelement 41 ungehindert, so dass es in die zweite optische Baugruppe 29 eintreten kann. Der Lichtweg des Lichtstrahls 38 der zweiten Lichtquelle 36 bleibt unverändert.

Wenn an der ersten Pockelszelle 8 keine Spannung anliegt, hingegen an der zweiten Pockelszelle 39, beaufschlagen beide Lichtquellen 2, 36 die erste optische Baugruppe 28. Das s-polarisierte Licht der ersten Lichtquelle 2 durchtritt die beiden Auskoppel-Strahlteiler 9, 40 ungehindert und tritt in die erste optische Baugruppe 28 ein. Das durch die zweite Pockelszelle in die p-Polarisation gedrehte Licht des Lichtstrahls 38 der zweiten Lichtquelle 36 wird vom zweiten Auskoppel-Strahlteiler 40 um 90° reflektiert und tritt in die erste optische Baugruppe 28 ein.

Es ist zu beachten, dass dann, wenn Licht beider Lichtquellen 2, 36 gemeinsam eine der optischen Baugruppen 28, 29 beaufschlagt, das Licht der beiden Lichtquellen 2, 36, welches gemeinsam durch diese optische Baugruppe 28, 29 verläuft, zwei unterschiedliche Polarisationszustände hat.

Zu beachten ist ferner, dass p-polarisiertes Licht, welches die erste optische Baugruppe 28 passiert hat, vom Einkoppel-Strahlteiler 35 in Fig. 5 nach oben längs eines Lichtwegs 42 reflektiert wird, von wo aus es durch eine entsprechende weitere Einkoppel-Einrichtung in Richtung der optischen Achse 4 zurückgeführt werden muss. Entsprechendes gilt für s-polarisiertes Licht, welches durch die zweite optische Baugruppe 29 geführt wird und den Einkoppel-Strahlteiler 35, ohne von diesem umgelenkt zu werden, in Richtung des Lichtwegs 42 durchtritt.

Wenn an beiden Pockelszellen 8, 39 Spannung angelegt ist, wird das Licht der Lichtquelle 2 durch die zweite optische Baugruppe 29 und das Licht der Lichtquelle 36 durch die erste optische Baugruppe 28 geleitet.

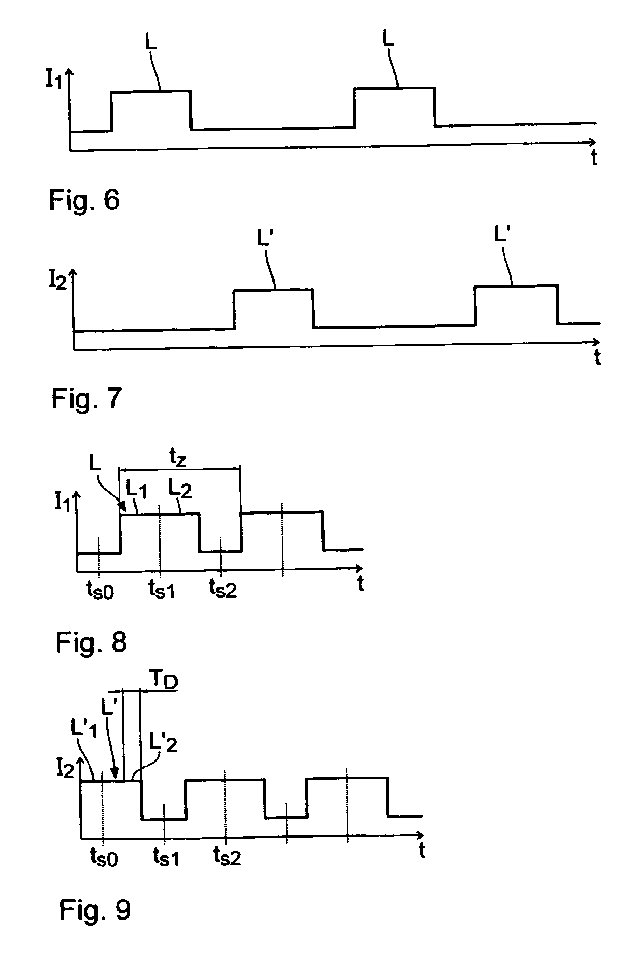

Fig. 6 und 7 zeigen einen möglichen zeitlichen Verlauf der Intensitäten I₁ von Lichtimpulsen L der ersten Lichtquelle 2 und I₂ von Lichtimpulsen L' der zweiten Lichtquelle 36. Die beiden Lichtquellen 2, 36 sind so zueinander synchronisiert, dass die Lichtimpulse L' während den zeitlichen Lücken zwischen zwei Lichtimpulsen L erzeugt werden. Der zweite Auskoppel-Strahlteiler 40 und das Umlenkelement 41 werden daher nie gleichzeitig von zwei Lichtimpulsen L, L' beaufschlagt. Auch ab dem Einkoppel-Strahlteiler 36 werden die nachfolgenden optischen Komponenten des Beleuchtungssystems 5 sowie auch das Retikel 19 und der Wafer 24 nicht gleichzeitig von Laserimpulsen L, L' beaufschlagt. Die Laserimpulse L, L' können durch entsprechende Schaltzeiten, wie vorstehend unter Bezugnahme auf die Fig. 2 bis 4 beschrieben, in zwei oder mehr Laserimpuls-Anteile L_{1,2} bzw. L'_{1,2} polarisationsoptisch unterteilt werden. Hierdurch wird, wie vorstehend schon unter Bezugnahme auf die Fig. 2 bis 4 beschrieben, die Beleuchtungslichtbelastung der optischen Komponenten reduziert.

Zwei gepulste Lichtquellen mit zeitlichen Impulsverläufen gemäß den Fig. 6 und 7 können auch vor einer einzigen Pockelszelle des Beleuchtungssystems zusammengeführt werden. Hierzu kann z. B. Licht 3' einer zweiten Lichtquelle 2' vor dem Strahlaufweiter 7 mit Hilfe eines Lochspiegels 2a, der um 45° zur optischen Achse 4 geneigt ist, in den Lichtweg des Lichtstrahls 3 eingekoppelt werden. Die Lichtquelle 2', der Lichtstrahl 3' und der Lochspiegel 2a sind in der Fig. 1 gestrichelt dargestellt. Der Lichtstrahl 3' ist ebenfalls s-polarisiert. Der Lichtstrahl 3' der Lichtquelle 2' hat idealerweise eine Mode, die im Bereich eines zentralen Lochs des Lochspiegels 2a praktisch keine Energie trägt. Durch das Loch des Lochspiegels 2a verläuft der Lichtstrahl 3 der Lichtquelle 2. Der Strahlaufweiter 7 wird dann mit den zusammengeführten Lichtstrahlen 3, 3' beaufschlagt. Die Pockelszelle 8 dient dann als gemeinsame Pockelszelle zur Beeinflussung des Polarisationszustandes der Lichtstrahlen 3, 3'.

Anhand der Fig. 8 und 9 wird eine weitere Möglichkeit zur Reduzierung der Beleuchtungslichtbelastung einzelner Komponenten des Beleuchtungssystems 5 nach Fig. 5 in Situationen, in denen Lichtimpulse L, L' der beiden Lichtquellen 2, 36 zeitlich überlappen, dargestellt. Fig. 8 zeigt hierbei die Intensität I₁ der Lichtimpulse L der Lichtquelle 2. Fig. 9 zeigt die Intensität I₂ der Lichtimpulse L' der Lichtquelle 36. Vor der Ankunft eines ersten Laserimpulses L wird bei t = tₛ₀ die Pockelszelle 8 spannungsfrei geschaltet. Ein Laserimpuls-Anteil L₁ passiert daher die erste optische Baugruppe 28. Ebenfalls bei t = tₛ₀ wird, synchron zur ersten Pockelszelle 8, die zweite Pockelszelle 39 ebenfalls spannungsfrei geschaltet. Der Zeitschaltpunkt tₛ₀ liegt mittig in einem Laserimpuls L' der zweiten Lichtquelle 36, so dass der nachfolgende Lichtimpuls-Anteil L'₂ nun durch die zweite optische Baugruppe 29 geleitet wird. In einem auf den Schaltzeitpunkt tₛ₀ folgenden Zeitraum T_{D} zwischen der steigenden Flanke des Laserimpulses L und der fallenden Flanke des Laserimpulses L', in dem die beiden Laserimpulse L, L' zeitlich überlappen, werden die beiden Laserimpulse L, L' also getrennt durch die optischen Baugruppen 28, 29 geleitet, so dass dort keine gleichzeitige Belastung durch beide Laserimpulse L, L' auftritt. Zu einem nächsten Schaltzeitpunkt tₛ₁ werden beide Pockelszellen 8, 30 synchron unter Spannung gesetzt. Der Zeitschaltpunkt tₛ₁ liegt dabei mittig in einem Laserimpuls L der Lichtquelle 2. Der nachfolgende Laserimpuls-Anteil L₂ tritt daher durch die zweite optische Baugruppe 29. Der zeitlich mit diesem Laserimpuls-Anteil L₂ überlappende Laserimpuls-Anteil L'₁ des nächsten Laserimpulses L' der zweiten Lichtquelle 36 wird hingegen durch die erste optische Baugruppe 28 geführt.

Zum Schaltzeitpunkt tₛ₂ mitten im nächsten Laserimpuls L' wiederholt sich, was vorstehend unter Bezugnahme auf den Zeitschaltpunkt tₛ₀ diskutiert wurde. Die Zeitschaltpunkte tₛ haben die doppelte Frequenz der Laserimpulse der einzelnen Lichtquellen 2, 36, wobei jeweils der Laserimpuls L, L' einer Lichtquelle halbiert und zwischen zwei Laserimpulsen L', L der anderen Lichtquelle geschalten wird. Durch diese Beschaltung wird erreicht, dass niemals das Licht beider Lichtquellen 2, 36 durch eine einzige optische Baugruppe 28, 29 geführt ist, was die Belastung der einzelnen optischen Komponenten der optischen Baugruppen 28, 29 entsprechend reduziert.

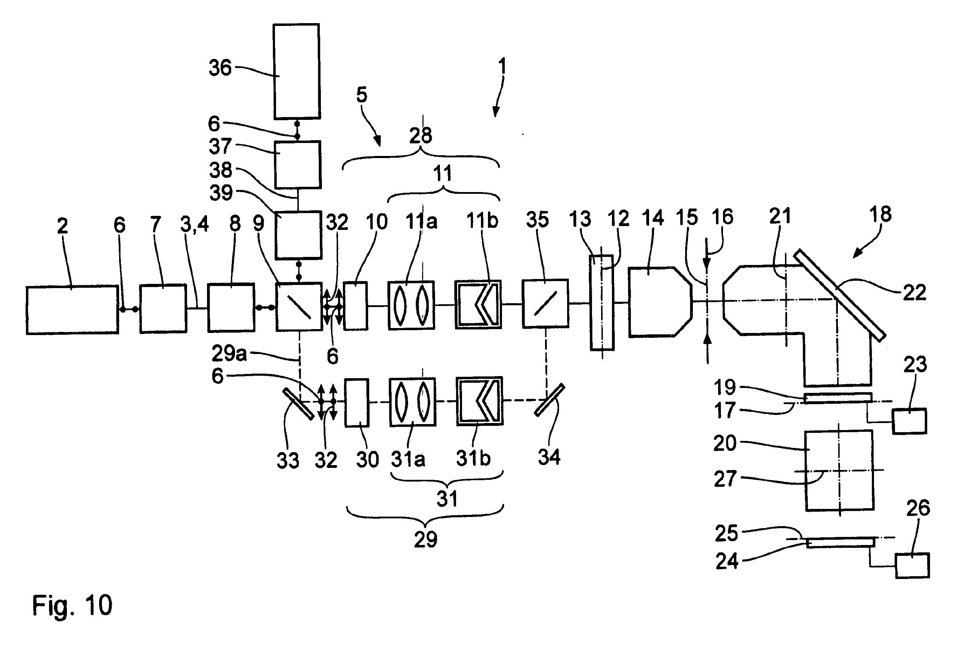

Fig. 10 zeigt eine weitere Ausgestaltung eines Beleuchtungssystems 5. Komponenten, die denjenigen entsprechen, die vorstehend schon unter Bezugnahme auf die Fig. 1 bis 9 erläutert wurden, tragen die gleichen Bezugsziffern und werden nicht nochmals im Einzelnen diskutiert. Die Variante nach Fig. 10 entspricht bis auf die Art der Auskopplung des Lichts der zweiten Lichtquelle 36 in der Variante nach Fig. 5. Zur Auskopplung des Lichtstrahls 38 der zweiten Lichtquelle 36 wird bei der Variante nach Fig. 10 der Auskoppel-Strahlteiler 9, der schon den Lichtstrahl 3 der Lichtquelle 2 auskoppelt, herangezogen.

Der Auskoppel-Strahlteiler 9 lässt einerseits das s-polarisierte Licht der Lichtquelle 2 und andererseits das s-polarisierte Licht der Lichtquelle 36 ungehindert durch, so dass die erste optische Baugruppe 28 mit s-polarisiertem Licht der Lichtquelle 2 und die zweite optische Baugruppe 29 mit s-polarisiertem Licht der zweiten Lichtquelle 36 beaufschlagt wird. Der Auskoppel-Strahlteiler 9 reflektiert p-polarisiertes Licht der Lichtquellen 2, 36 jeweils um 90°, so dass die erste optische Baugruppe 28 mit p-polarisiertem Licht der zweiten Lichtquelle 36 und die zweite optische Baugruppe 29 mit p-polarisiertem Licht der ersten Lichtquelle 2 beaufschlagt wird.

Hinsichtlich der Einkopplung entspricht die Variante nach Fig. 10 derjenigen nach Fig. 5.

Hinsichtlich der Schaltzeiten der Pockelszellen 8, 39 können hier die Schaltzeit-Beispiele genutzt werden, die vorstehend unter Bezugnahme auf die Fig. 6 bis 9 beschrieben wurden.

Der Wechsel der Lichteigenschaft zum Ändern des Lichtwegs zwischen den optischen Baugruppen 28, 29 vollzieht sich bei Verwendung der Pockelszellen 8, 39 innerhalb weniger Nanosekunden. Je nach eingesetzter Lichteigenschafts-Wechseleinrichtung kann sich der Wechsel auch innerhalb von 10 oder 100 Nanosekunden, innerhalb einer Mikrosekunde oder auch innerhalb einer Sekunde vollziehen.

Das Umschalten der Pockelszellen 8, 39 kann insbesondere periodisch mit fester Frequenz erfolgen. Diese Frequenz kann z. B. bei 1 kHz liegen. Auch andere Frequenzen zwischen 1 Hz und 10 kHz sind möglich.

Durch das Wechseln der Lichteigenschaft kann insbesondere gewährleistet werden, dass die maximale Energie pro Laserimpuls nach Erzeugung eines Beleuchtungssettings in der Pupillenebene 12 um mindestens 25% niedriger liegt als dies bei einem konventionellen Beleuchtungssystem bei gleichem Setting, gemessen am gleichen Ort, der Fall wäre.

Die maximale Intensität an einem bestimmten Ort des Beleuchtungssystems kann bei den erfindungsgemäßen Ausgestaltungen um mehr als 25% niedriger sein als bei konventionellen Beleuchtungssystemen mit nur einer optischen Baugruppe.

Anstelle des Einkoppel-Strahlteilers 35 kann auch ein die beiden Lichtwege integrierendes optisches System in Form z. B. einer Linse, eines Objektivs oder eines Brechkraft tragenden Spiegels oder mehrerer derartiger Spiegel vorgesehen sein. Ein Beispiel für ein derartiges optisch integrierendes System ist in der WO 2005/027207 A1 dargestellt.

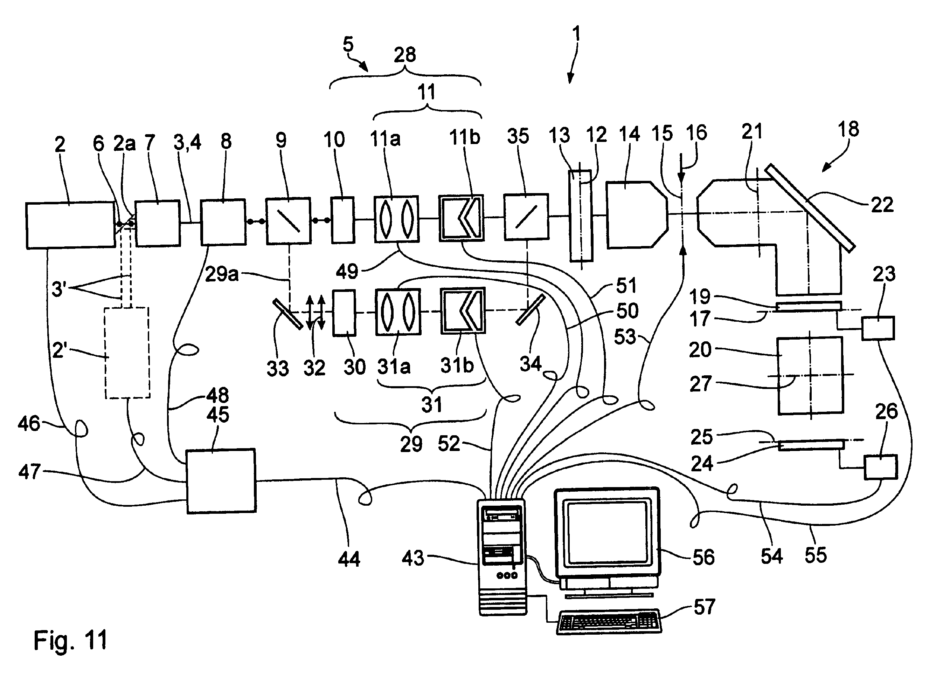

Fig. 11 zeigt in einer zu Fig. 1 ähnlichen Darstellung eine Weiterbildung der Mikrolithografie-Projektionsbelichtungsanlage 1 zur Vorgabe anteiliger Beleuchtungen des Beleuchtungsfeldes einerseits über die erste optische Baugruppe 28 und andererseits über die zweite optische Baugruppe 29, also z. B. zur vorgegebenen Doppelbelichtung des Retikels 19 mit den beiden über die optischen Baugruppen 28, 29 einstellbaren Beleuchtungssettings. Komponenten der Projektionsbelichtungsanlage 1 nach Fig. 11, die denjenigen entsprechen, die vorstehend schon unter Bezugnahme auf die Projektionsbelichtungsanlage 1 nach den Fig. 1 bis 10 erläutert wurden, tragen die gleichen Bezugsziffern und werden nicht nochmals im Einzelnen diskutiert.

Zur Vorgabe der anteiligen Beleuchtung hat die Projektionsbelichtungsanlage 1 nach Fig. 11 eine zentrale Steuereinrichtung in Form eines Rechners 43. Über eine Signalleitung 44 steht der Rechner 43 mit einem Steuermodul 45 in Verbindung. Letzteres steht über eine Signalleitung 46 mit der Lichtquelle 2, über eine Signalleitung 47 mit der Lichtquelle 2' und über eine Signalleitung 48 mit der Pockelszelle 8 in Signalverbindung.
Über Signalleitungen 49, 50 steht der Rechner 43 mit den Zoom-Systemen 11a, 31a in Verbindung. Über Signalleitungen 51, 52 steht der Rechner 43 mit den Axiconanordnungen 11b, 31b in Verbindung. Über eine Signalleitung 53 steht der Rechner 43 mit dem REMA 16 in Verbindung. Über eine Signalleitung 54 steht der Rechner 43 mit dem Waferstage 26 und über eine Signalleitung 55 mit dem Retikelstage 23 in Verbindung. Zum Rechner 43 gehören ein Bildschirm 56 und eine Tastatur 57.

Der Rechner 43 gibt die Schaltzeitpunkte tₛ für die Pockelszelle 8 vor. Durch die Wahl der Schaltzeitpunkte über die Zeit kann mit Hilfe des Rechners 43 vorgegeben werden, mit welcher Intensität das Retikel 19 mit welchem der beiden Beleuchtungssettings beaufschlagt wird, die über die beiden optischen Baugruppen 28, 29 vorgegeben werden können. Die Schaltzeitpunkte für die Pockelszelle 8 können mit Triggerimpulsen der Lichtquellen 2, 2' synchronisiert werden, sodass die Schaltzeitpunkte phasenrichtig während der Laserpulse erfolgen, wie vorstehend im Zusammenhang mit den Figuren 2 bis 8 beschrieben.

Die Vorgabe der Schaltzeitpunkte tₛ erfolgt abhängig vom jeweils eingestellten Beleuchtungssetting in den optischen Baugruppen 28, 29. Die Informationen zum jeweils eingestellten Beleuchtungssetting erhält der Rechner 43 über die Signalleitungen 49 bis 52. Über die entsprechenden Signalleitungen kann der Rechner 43 auch ein vorgegebenes Beleuchtungssetting durch Ansteuerung entsprechender Verlagerungsantriebe für die Zoom-Systeme 11 a, 31 a und für die Axiconanordnungen 11b, 31b aktiv ansteuern.

Die Vorgabe der Schaltzeitpunkte tₛ erfolgt zudem in Abhängigkeit vom jeweiligen Scanvorgang. Informationen hierzu erhält der Rechner 43 über die Steuerleitungen 53 bis 55 vom REMA 16 und den Stages 23, 26. Je nach Vorgabewert kann der Rechner 43 auch über die Steuerleitungen 53 bis 55 durch Ansteuerung entsprechender Antriebe auch aktiv die Betriebsposition des REMA 16 bzw. der Stages 23, 26 verändern. Der Rechner 43 kann auf diese Weise abhängig von der jeweiligen Betriebssituation der Projektionsbelichtungsanlage 1 sicherstellen, dass jede der beiden optischen Baugruppen 28, 29 genügend Licht zur Beleuchtung des Beleuchtungsfeldes auf dem Retikel 19 beisteuert. Der jeweilige Lichtbeitrag wird vom Rechner 43 durch Integration der Intensitätskurven (vgl. Fig. 2 bis 4 bzw. 7 bis 9) bestimmt. Ggf. überschüssiges Licht, welches nicht zur Projektionsbelichtung herangezogen werden soll, kann mit Hilfe einer zweiten Pockelszelle und einem nachgeordneten Polarisator aus dem Belichtungsweg ausgekoppelt werden.

Die zentrale Steuereinrichtung 43 kann zusätzlich noch mit dem Auskoppelelement 9 und/oder dem Einkoppelelement 35 in Signalverbindung stehen, falls dies zur Vorgabe einer anteiligen Beleuchtung des Beleuchtungsfeldes mit den über die optischen Baugruppen 28, 29 realisierbaren Beleuchtungssettings erforderlich ist.

Über die zentrale Steuereinrichtung 43 ist eine zeitanteilige Beleuchtung des Beleuchtungsfeldes auf dem Retikel 19 über die erste optische Baugruppe 28 und die zweite optische Baugruppe 29 möglich. Alternativ oder zusätzlich ist es mit Hilfe der zentralen Steuereinrichtung 43 auch möglich, eine intensitätsanteilige Beleuchtung des Beleuchtungsfeldes über die erste optische Baugruppe 28 und die zweite optische Baugruppe 29 zu realisieren. Beispielsweise ist es möglich, das Beleuchtungsfeld mit 30 % einer Gesamtintensität über die erste optische Baugruppe 28 und mit 70 % der Gesamtintensität über die zweite optische Baugruppe 29 zu beleuchten. Dies kann statisch erfolgen, sodass diese Prozentanteile über einen vorgegebenen Zeitraum nicht geändert werden. Alternativ ist es auch möglich, die Anteile dynamisch zu verändern. Hierzu kann die Pockelszelle 8 beispielsweise mit einer Sägezahnkurve mit Zeitbasis 1 ns angesteuert werden. Hierzu weist die Ansteuerung der Pockelszelle 8 mindestens einen Hochspannungsgenerator auf. Wenn schnell zwischen zwei Hochspannungen umgeschaltet werden soll, hat die Ansteuerung der Pockelszelle 8 zwei Hochspannungsgeneratoren. Neben Hochspannungswechseln auf einer Nanosekunden-Zeitskala können zusätzliche Hochspannungswechsel z. B. auf einer Millisekunden-Zeitskala erfolgen, sodass, gemessen an der Zeitdauer der Laserimpulse, langsame Überblendungen zwischen den über die optischen Baugruppen 28, 29 vorgebbaren Beleuchtungssettings möglich sind.

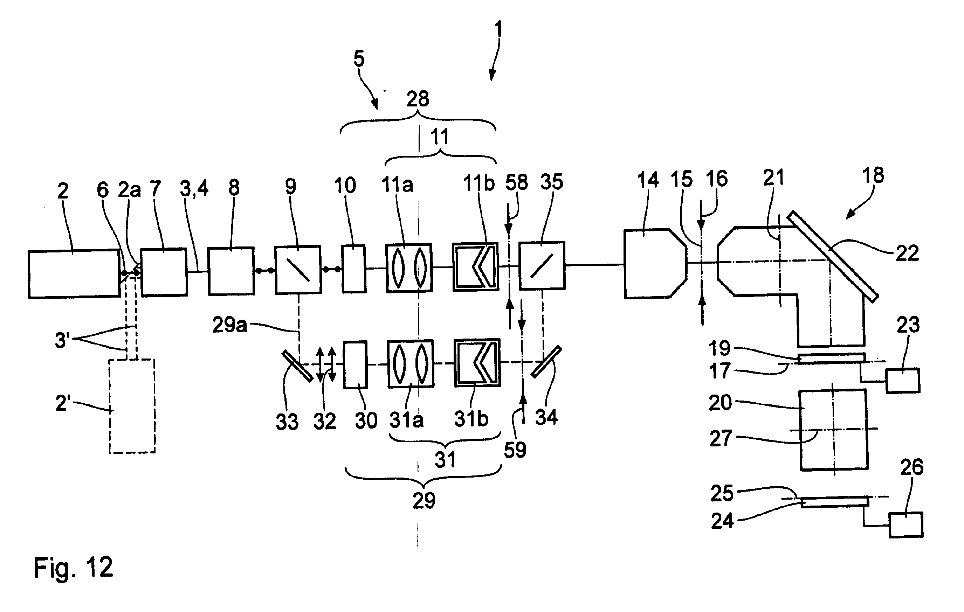

Fig. 12 zeigt in einer zu Fig. 1 ähnlichen Darstellung eine weitere Variante einer Projektionsbelichtungsanlage 1. Komponenten, die denjenigen entsprechen, die vorstehend schon unter Bezugnahme auf die Fig. 1 bis 11 erläutert wurden, tragen die gleichen Bezugsziffern und werden nicht nochmals im Einzelnen diskutiert.

Im Unterschied zur Projektionsbelichtungsanlage nach den Fig. 1, 5, 10 und 11 hat die Projektionsbelichtungsanlage 1 nach Fig. 12 Pupillenformungsebenen 58, 59, die jeweils in den optischen Wegen zu den optischen Baugruppen 28, 29 angeordnet, diesen also direkt zugeordnet sind. Die Pupillenformungsebene 58 ist der Axiconanordnung 11b der ersten optischen Baugruppe 28 direkt nachgeordnet. Die Pupillenformungsebene 59 ist der Axiconanordnung 31b der zweiten optischen Baugruppe 29 direkt nachgeordnet, also noch im Auskuppelast 29a angeordnet.

Bei der Ausführung nach Fig. 12 ersetzen die Pupillenformungsebenen 58, 59 die Pupillenformungsebene 12 nach Fig. 12. Alternativ ist es möglich, dass die Pupillenformungsebenen 58, 59 optisch konjugierte Ebenen der Pupillenformungsebene 12 darstellen.

Den Pupillenformungsebenen 58, 59 können individuelle Rasterelemente entsprechend dem Rasterelement 13 der Projektionsbelichtungsanlage 1 nach Fig. 1 zugeordnet sein.

Bei der Ausführung des Beleuchtungssystems 5 nach Fig. 12 kann durch Einsatz entsprechender optischer Komponenten in den optischen Baugruppen 28 und 29 eine Pupillenformung, also die Einstellung eines Beleuchtungssettings, vorgenommen werden, wie dies grundsätzlich aus dem Stand der Technik, z. B. aus der WO 2005/027207 A, schon bekannt ist.

Weitere Komponenten zur Beeinflussung eines Pupillensettings, die in den optischen Baugruppen 28, 29 zum Einsatz kommen können, sind beschrieben in der WO 2005/069081 A2, EP 1 681 710 A1, WO 2005/116772 A1, EP 1 582 894 A1 und WO 2005/027207 A1.

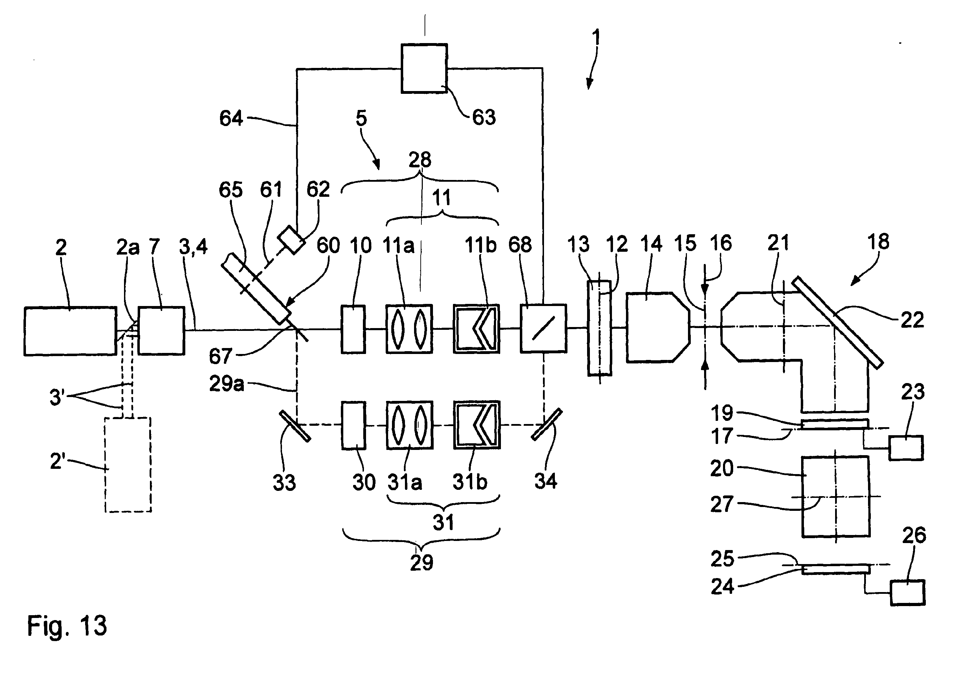

Fig. 13 zeigt eine weitere Ausführung eines Beleuchtungssystems 5 einer Projektionsbelichtungsanlage 1. Komponenten, die denjenigen entsprechen, die vorstehend schon unter Bezugnahme auf die Fig. 1 bis 12 beschrieben wurden, tragen die gleichen Bezugszeichen und werden nicht nochmals im Einzelnen erläutert.

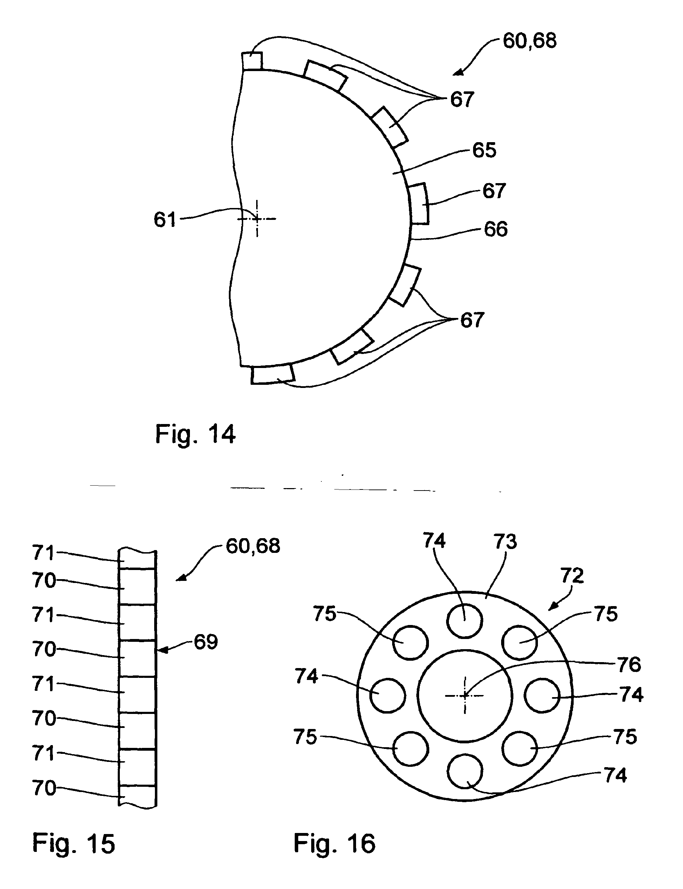

Im Unterschied zu den Beleuchtungssystemen 5 nach den Fig. 1 bis 12 beruht der Auskoppelmechanismus zwischen den optischen Baugruppen 28, 29 beim Beleuchtungssystem 5 nach Fig. 13 nicht auf der Beeinflussung einer Lichteigenschaft, die erst nachfolgend zu einer Wegbeeinflussung genutzt wird, sondern auf einer direkten Wegbeeinflussung des Beleuchtungslichts. Hierzu ist ein Auskoppelelement 60 in Form eines Spiegelelements vorgesehen. Das Auskoppelelement 60 ist am Ort des Auskoppel-Strahlteilers 9 z. B. der Ausführung nach Fig. 1 angeordnet und um eine in der Zeichenebene der Fig. 13 liegende Achse 61 drehbar. Diese Drehbewegung wird von einem Drehantrieb 62 angetrieben. Letzterer steht mit einem Synchronisations-Steuermodul 63 über eine Signalleitung 64 in Verbindung. Das Auskoppelelement 60 hat einen scheibenförmigen Spiegelträger 65, der in den Fig. 13, 14 ausschnittsweise dargestellt ist. Über eine Umfangswand 66 des Spiegelträgers 65 hinausragend ist auf diesem eine Mehrzahl von Einzelspiegeln 67 angeordnet.

Die Darstellung nach Fig. 14 ist nicht maßstabsgetreu. Tatsächlich kann eine Vielzahl von Einzelspiegeln 67, z. B. mehrere hundert derartiger Einzelspiegel, auf dem Spiegelträger 65 vorgesehen sein.

In Umfangsrichtung entspricht der Abstand zweier benachbarter Einzelspiegel 67 der Umfangserstreckung eines Einzelspiegels 67. Die Einzelspiegel 67 haben alle die gleiche Umfangserstreckung.

Bei rotierendem Spiegelträger 65 wird das Beleuchtungslicht entweder von einem der Einzelspiegel 67 reflektiert oder zwischen den Einzelspiegeln 67 unbeeinflusst durchgelassen. Reflektiertes Beleuchtungslicht gelangt in den Auskoppelast 29a, also in die zweite optische Baugruppe 29. Durchgelassenes Beleuchtungslicht gelangt in die erste optische Baugruppe 28.

Am Ort des Einkoppel-Strahlteilers 35 der Ausführung nach Fig. 1 ist bei der Ausführung nach Fig. 13 ein Einkoppelelement 68 angeordnet, welches genauso aufgebaut ist wie das Auskoppelelement 60. In der Fig., 13 ist das Einkoppelelement 68 lediglich schematisch dargestellt. Das Einkoppelelement 68 wird, gesteuert über das Steuermodul 63, synchron zum Auskoppelelement 60 angetrieben, sodass immer dann, wenn das Auskoppelelement 60 das Beleuchtungslicht durchlässt, auch das Einkoppelelement 68 das Beleuchtungslicht unbeeinflusst durchlässt. Wenn das Auskoppelelement 60 hingegen das Beleuchtungslicht mit einem der Einzelspiegel 67 reflektiert, wird dieses ausgekoppelte Beleuchtungslicht nach Durchlaufen des Auskoppelastes 29a von einem entsprechenden Einzelspiegel des Einkoppelelements 68 reflektiert und dadurch in den anschließenden gemeinsamen Strahlengang des Beleuchtungslichts hin zum Retikel 19 eingekoppelt.

Die Drehzahl des Einkoppelelements 60 und des Auskoppelelements 68 ist zur Impulsfolge der Lichtquellen 2, 2' synchronisiert.

Über das Aspektverhältnis der Umfangserstreckung der Einzelspiegel 67 zur Umfangserstreckung der zu den Lücken zwischen benachbarten Einzelspiegeln 67 des Auskoppelelements 60 und des Einkoppelelements 68 lässt sich der Anteil der Beleuchtung über die erste optische Baugruppe 28 einerseits und über die zweite optische Baugruppe 29 andererseits vorgeben. Derartige Aspektverhältnisse können über die Dimensionierung und Anordnung der Einzelspiegel 67 auf der Umfangswand 66 des Spiegelträgers 65 z. B. zwischen 1:10 und 10:1 vorgegeben werden.

Eine weitere Ausführung eines Auskoppelelements 60, welches in dieser Form auch als Einkoppelelement 68 zum Einsatz kommen kann, ist in der Fig. 15 dargestellt. Das Auskoppelelement 60 liegt in Form einer bandförmigen Spiegelfolie 69 vor. Letztere ist unterteilt in Einzelspiegel 70, zwischen denen jeweils für das Beleuchtungslicht transparente Lücken 71 vorliegen. Die Spiegelfolie 69 liegt als Endlosband vor, welches über entsprechende Umlenkrollen so geführt wird, dass es am Ort der Einzelspiegel 67 der Ausführung nach Fig. 13 senkrecht zur Zeichenebene durch den Strahlengang des Beleuchtungslichts 3 geführt wird. Solange das Beleuchtungslicht von einem der Einzelspiegel 70 reflektiert wird, wird es vom Auskoppelelement 60 in den Auskoppelast 29a reflektiert bzw. vom Einkoppelelement 68 wieder in den gemeinsamen Strahlengang hin zum Retikel 19 eingekoppelt. Von den transparenten Lücken 71 wird das Beleuchtungslicht nicht beeinflusst, sodass es diese beim Auskoppelelement 60 hin zur ersten optischen Baugruppe 28 durchtritt und beim Einkoppelelement 68 hin zum Retikel 19 durchtritt.

Für die Ansteuerung der angetriebenen Spiegelfolie 69 über das Steuermodul 63 sowie für das Aspektverhältnis der Längen der Einzelspiegel 70 zu den Längen der Lücken 71 gilt, was vorstehend zum Aspektverhältnis im Zusammenhang mit den Einkoppel- bzw. Auskoppelelementen 60, 68 nach Fig. 14 ausgeführt wurde.

Fig. 16 zeigt eine Polarisations-Wechseleinrichtung 72, welche anstelle des Auskoppelelements 60 zum Einsatz kommen kann. Die Polarisations-Wechseleinrichtung 72 ist beim Beleuchtungssystem 5 nach der Fig. 1 am Ort der Pockelszelle 8 angeordnet. Die Polarisations-Wechseleinrichtung 72 ist um eine Drehachse 76 drehangetrieben, die parallel zum Lichtstrahl 3 zwischen der Lichtquelle 2 und dem Auskoppel-Strahlteiler 9 verläuft. Die Polarisations-Wechseleinrichtung 72 ist um die Drehachse 76 durch einen entsprechenden Drehantrieb, synchronisiert über das Steuermodul 63, drehangetrieben. Die Polarisations-Wechseleinrichtung 72 hat einen Revolverhalter 73 mit insgesamt acht Revolveraufnahmen 74. Auch eine erheblich größere Anzahl von Aufnahmen 74 ist möglich. In Umfangsrichtung in jeder zweiten dieser Aufnahmen 74 ist eine Lambda/2-Platte 75 angeordnet. Die anderen vier Aufnahmen 74 sind frei. Die optischen Achsen der insgesamt vier Lambda/2-Platten 75 sind so angeordnet, dass dann, wenn eine der Lambda/2-Platten 75 im Strahlengang des Beleuchtungslichts vorliegt, die Polarisation des Beleuchtungslicht beim Durchtritt durch die Lambda/2-Platte um 90° gedreht wird. Die Polarisations-Wechseleinrichtung 72 hat dann die gleiche Funktion wie die Pockelszelle 8 bei angelegter Hochspannung.

Solange eine der freien Aufnahmen 74 das Beleuchtungslicht unbeeinflusst durchlässt, hat die Polarisations-Wechseleinrichtung 72 die Funktion einer spannungsfreien Pockelszelle.

Alternativ zur Polarisations-Wechseleinrichtung 72 kann auch eine drehbare polarisationsbeeinflussende Platte zum Einsatz kommen, wie beispielsweise in der WO 2005/069081 A beschrieben.

Als weitere Alternative zur Polarisations-Wechseleinrichtung 72 kann auch eine Lambda/2-Platte dienen, die im Strahlengang des Beleuchtungs-Lichtstrahls 3 zum Beispiel am Ort der Pockelszelle 8 in der Anordnung nach der Fig. 1 und diese ersetzend angeordnet ist. Durch Drehung der Lambda/2-Platte um eine Drehachse parallel zum diese durchtretenden Beleuchtungs-Lichtstrahl 3 kann die Polarisationsebene des Beleuchtungslichts zum Beispiel um 90° gedreht werden, sodass die Lambda/2-Platte eine polarisationsbeeinflussende Wirkung entsprechend derjenigen der Pockelszelle 8 in der Ausführung nach Fig. 1 hat. Die optische Achse der Lambda/2-Platte liegt in der Regel in der Plattenebene. Auch andere Orientierungen der optischen Achse der Lambda/2-Platte zur Plattenebene sind möglich. Polarisationsbeeinflussende Elemente nach Art von Lambda/2-Platten sind beispielsweise beschrieben in der DE 199 21 795 A1, in der US 2006/0055834 A1 und in der WO 2006/040184 A2.

Vorstehend wurden die Ausführungsbeispiele anhand von Beleuchtungssystemen beschrieben, die die beiden optischen Baugruppen 28, 29 von vorneherein aufweisen. Erfindungsgemäß ist es genauso möglich, bestehende Projektionsbelichtungsanlagen mit einer optischen Baugruppe, die der ersten optischen Baugruppe 28 der vorstehend beschriebenen Ausführungsbeispiele entspricht, mit einem Ergänzungsmodul so nachzurüsten, dass eines der vorstehend beschriebenen Ausführungsbeispiele resultiert. Das Nachrüst-Ergänzungsmodul umfasst neben der zweiten optischen Baugruppe 29 noch das Auskoppelelement 9 oder 60 sowie das Einkoppelelement 35 oder 68. Je nach Ausführung des Ergänzungsmoduls hat dieses zudem noch die Lichteigenschafts-Wechseleinrichtung, also beispielsweise die Pockelszelle 8 oder die Polarisations-Wechseleinrichtung 72. Zum Ergänzungsmodul kann ferner auch noch die zentrale Steuereinrichtung 43 gehören. Schließlich kann das Ergänzungsmodul auch noch eine weitere Lichtquelle 2' oder 36 mit den entsprechenden Ein- bzw. Auskoppeloptiken umfassen, wie vorstehend im Zusammenhang insbesondere mit den Fig. 1 und 5 beschrieben.

Vorstehend wurden die Ausführungsbeispiele anhand zweier unterschiedlicher Beleuchtungssettings mit bevorzugt unterschiedlichen räumlichen Intensitätsverteilungen in der Pupille bzw. Pupillenebene 12 beschrieben. Dabei wurde unter Beleuchtungssetting hauptsächlich die räumliche Intensitätsverteilung in einer Pupillenebene 12 verstanden. Aufgrund der Bedeutung der räumlichen Polarisationsverteilung in der Pupille für Lithographieanwendungen wird unter dem Begriff des Beleuchtungssettings neben der räumlichen Intensitätsverteilung auch synonym die räumliche Polarisationsverteilung in der Pupille verstanden.

Mit Hilfe der mindestens zwei optischen Baugruppen 28, 29 ist es auch möglich, ein und dasselbe räumliche Beleuchtungssetting im Hinblick auf die räumliche Intensitätsverteilung in der Pupillenebene 12 einzustellen, wobei sich die Beleuchtungssettings lediglich im Hinblick ihrer räumlichen Polarisationsverteilung in der Pupillenebene 12 unterscheiden. Abhängig von den abzubildenden Strukturen kann zum Beispiel das zweite Beleuchtungssetting eine in der Pupillenebene 12 um 90° gedrehte Polarisationsverteilung relativ zur Polarisationsverteilung des ersten Beleuchtungssettings in der Pupillenebene 12 aufweisen. Somit ist es möglich durch geeignete Ansteuerung der beiden optischen Baugruppen 28, 29, deren anteilige Beleuchtung mit Hilfe einer Steuer- oder Kontrolleinheit, wie z.B. des Rechners 43, so zu steuern, dass bei ein und denselben Intensitäts-Beleuchtungssettings, mit dem das Retikel 19 beleuchtet wird, verschiedene Polarisationszustände bei der Beleuchtung realisiert werden können.

Dies ist zum Beispiel dann vorteilhaft, wenn es gilt, Fertigungsprozesse von Entwicklungsanlagen in den Entwicklungszentren auf Produktionsanlagen in Herstellungsfabriken für mikrostrukturierte Bauelemente bzw. Chipfabriken zu übertragen, und sich diese unterschiedlichen Anlagen, insbesondere deren Projektionsobjektive zur Abbildung von Maskenstrukturen auf den Wafer im Hinblick auf ihre Polarisationsübertragungseigenschaften unterscheiden. In einem solchen Fall ist es von Vorteil, wenn bei ein und demselben Intensitäts-Beleuchtungssetting, welches sich in der Entwicklung als optimal für eine bestimmte Chipstruktur erwiesen hat, durch Einsatz der beiden optischen Baugruppen die Polarisationseigenschaft nachgeregelt werden kann, so dass auch die damit betriebenen Produktionsanlagen optimale Chipstrukturen auf den Wafer abbilden. Eine andere Anwendung der Änderung der Polarisationseigenschaft bei ein und demselben Intensitäts-Beleuchtungssetting ergibt sich beim Belichten von Chips in einem Scanvorgang, bei dem zwar ein und dasselbe Intensitäts-Beleuchtungssetting für die Belichtung des ganzen Chips ausgewählt wurde, jedoch die Chipstrukturen in unterschiedlichen Bereichen des Chips durch unterschiedliche Polarisation kontrastreicher abgebildet werden können. In einem solchen Fall empfiehlt es sich die Polarisationseigenschaften während dem Scanvorgang zu ändern. Daneben kann auch die räumliche Intensitätsverteilung der Beleuchtungssettings (Intensitäts-Beleuchtungssetting), erzeugt durch die wenigstens zwei optischen Baugruppen, während des Scanvorgangs geändert werden.

Ein weiterer Aspekt der Änderung der Polarisationseigenschaften bei ein und denselben Beleuchtungssetting ergibt sich aus der sogenannten polarisationsinduzierten Doppelbrechung. Dies ist ein Materialeffekt, der darauf basiert, dass bei polarisierter Bestrahlung des Materials mit der Zeit im vom Beleuchtungslicht durchtretenen Material Spannungsdoppelbrechung hervorgerufen wird. Derartige Materialbereiche mit beleuchtungsinduzierter Spannungsdoppelbrechung bilden Defektbereiche im Material. Um diesen Materialdefekten vorzubeugen wird, wenn möglich, zirkulares oder unpolarisiertes Licht verwendet bzw. bevorzugt. Durch die vorliegende Erfindung ist es nun möglich, die Polarisationseigenschaft bei ein und demselben Intensitäts-Beleuchtungssetting zu ändern, so dass die polarisationsinduzierte Doppelbrechung zumindest für die nach dem Einkoppelelement folgenden optischen Komponenten reduziert werden kann.

Anhand der vorstehenden Ausfiihrungsbeispiele ist es auch möglich, beliebige Beleuchtungssettings mit beliebigen Polarisationsverteilungen in der Pupillenebene 12 mit Hilfe der mindestens zwei optischen Baugruppen 28, 29 zu erzeugen. Hierbei ist es auch möglich, besonders schnell zwischen den Beleuchtungssettings mit den entsprechenden Polarisationszuständen zu wechseln, bis hin zu mehreren Wechseln innerhalb eines Lichtimpulses. Ferner ist es möglich, langsame Wechsel der Beleuchtungssettings synchron mit dem Scanvorgang zu ermöglichen und dabei gleichzeitig die Polarisationsverteilung innerhalb der mindestens zwei optischen Baugruppen 28, 29 durch entsprechende polarisationsbeeinflussende optische Elemente, wie z.B. einer Polarisationsdreheinrichtung, wie in WO 2006/040184 A2 beschrieben, oder einer rotierbaren Lambda/2-Platte, wie z.B. in W02005/027207 A1 ausgeführt, die in den Baugruppen 28, 29 oder in Strahlrichtung nach diesen Baugruppen angeordnet sind, z. B. zeitlich korreliert mit dem Scanvorgang zu ändern.

Selbst sehr schnelle Wechsel der Polarisationseigenschaft innerhalb der beiden Baugruppen 28, 29 sind durch polarisationsbeeinflussende optische Elemente möglich, wie z.B. in WO 2006/040184 A2 dargestellt. Insofern bietet die Erfindung die Flexibilität, Chipstrukturen oder Kombinationen von unterschiedlichen Chipstrukturen von Waferteilbereichen z. B. beim Scanvorgang mit an die Abbildungsanforderungen angepassten Intensitäts-Beleuchtungssettings und/oder räumlicher Polarisationsverteilungen in der Pupillenebene der Projektionsbelichtungsanlage für eine hinsichtlich Kontrast und Auflösung optimierte Abbildung zu beleuchten. Hierdurch ergeben sich für die Chiphersteller neue Möglichkeiten der Anordnung unterschiedlicher Chipstrukturen auf einem Wafer, da aufgrund der Erfindung Chipstrukturen kombiniert werden können, die bisher aufgrund der unterschiedlichen Anforderungen an die notwendigen Beleuchtungssettings auf ein und denselben Wafer vermieden wurden, bzw. nicht mit der höchsten Integrationsdichte abbildbar waren.

Mit den vorstehenden Ausführungsbeispielen ist es genauso möglich, mit Hilfe der mindestens zwei optischen Baugruppen 28, 29 ein und dasselbe Intensitäts-Beleuchtungssetting auch mit der gleichen räumlichen Polarisationsverteilung, also zwei im Rahmen vorgegebener Toleranzen gleiche Beleuchtungssettings, in der Pupillenebene 12 bereitzustellen. Dies ist zum Beispiel dann vorteilhaft, wenn beim Scanvorgang für bestimmte Teilbereiche eines Chips, zur kontrastreichen Abbildung von Chipstrukturen in den Teilbereich hinein, eine Doppelbelichtung mit zwei unterschiedlichen Settings und/ oder unterschiedlichen Polarisationszuständen unangebracht wäre.

Ein weiterer Vorteil beim Betreiben beider optischen Baugruppen 28, 29 mit gleichen Beleuchtungssettings und gleichen räumlichen Polarisationsverteilungen in der Pupillenebene 12 liegt darin, dass beim Schalten während des Lichtimpulses gemäß dem Schaltzeit-Beispiel nach Fig. 3 die Spitzenbelastung, oder beim Schalten zwischen den Lichtimpulsen gemäß dem Schaltzeit-Beispiel nach Fig. 2, die Dauerbelastung der optischen Komponenten in den beiden optischen Baugruppen 28, 29 reduziert wird, verglichen zum Betrieb eines gleichen Beleuchtungssettings mit gleicher Polarisationsverteilung in einem konventionellen Beleuchtungssystem, oder verglichen zum Betrieb des Beleuchtungssettings in nur einer der beiden optischen Baugruppen 28, 29.

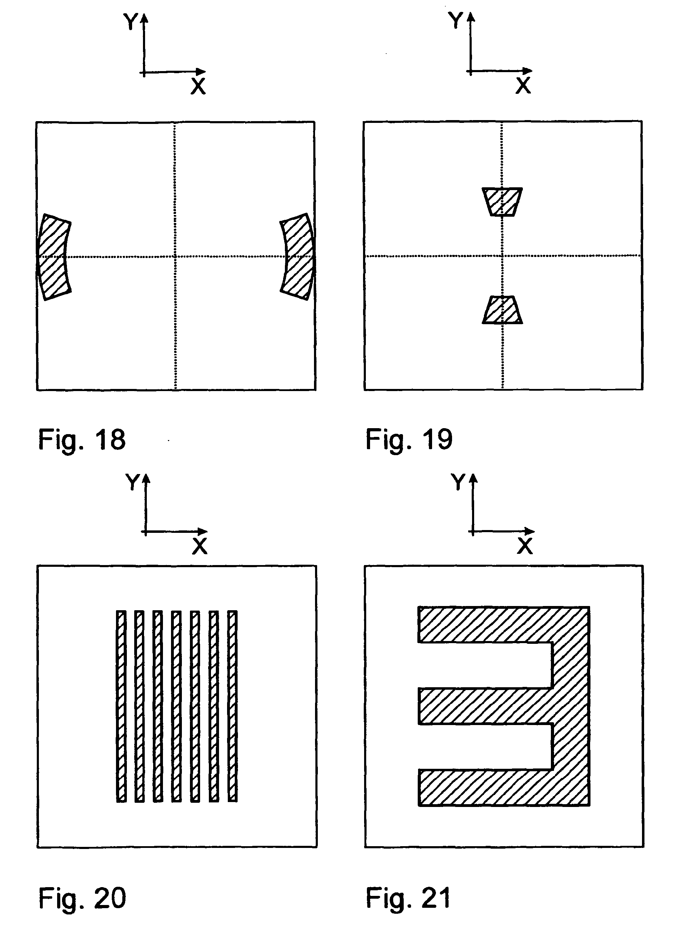

In den Figuren 18 bis 29 sind Beispiele von Kombination von unterschiedlichen Beleuchtungssettings in der Pupillenebene 12 mit zugehörigen Maskenstrukturen angegeben. Dabei stellen die in den Figuren 18, 19, 22, 23 und 26, 27 angegebenen Beispiele nur einen kleinen Ausschnitt der durch die Erfindung realisierbaren Beleuchtungssettings dar.

Nachfolgend werden zur Charakterisierung die Begriffe "inneres Sigma (inneres σ)", "äußeres Sigma (äußeres σ')" und "Polbreite" verwendet. Das innere σ (sigma inner) ist hierbei als der Pupillenradius definiert, in dem 10 % der Beleuchtungslicht-Intensität in der Pupille liegen. Das äußere σ (sigma outer) ist hierbei als der Pupillenradius definiert, in dem 90 % der Beleuchtungslicht-Intensität in der Pupille liegen. Die Polbreite ist definiert als der Öffnungswinkel zwischen Begrenzungsradien einer in der Pupillenebene ausgeleuchteten Struktur, an denen die Intensität auf 50 % des Intensitätsmaximums dieser Struktur abgefallen ist.

Figur 18 zeigt ein Beleuchtungssetting in Form einer Dipol-Beleuchtung in X-Richtung mit einer Polbreite von 35°, einem inneren σ von 0.8 und einem äußeren σ von 0.99. Figur 19 zeigt ein weiteres Beleuchtungssetting in Form einer Dipol-Beleuchtung in Y-Richtung mit einer Polbreite von 35°, einem inneren σ von 0.3 und einem äußeren σ von 0.5. Hierbei kann das Beleuchtungssetting nach Figur 18 durch die Baugruppe 28 und das Beleuchtungssetting nach Figur 19 durch die Baugruppe 29 oder umgekehrt realisiert werden. Falls diese Beleuchtungssettings polarisiert betrieben werden sollen, ist es von Vorteil, wenn das Beleuchtungssetting nach Figur 18 linear in Y-Richtung polarisiert ist. Die Polarisationsrichtung des Beleuchtungssettings nach Fig. 19 ist hierbei für den Kontrast der Abbildung nicht von wesentlicher Bedeutung, da aufgrund des maximalen äußeren σ von 0.5 die Lichtstrahlen noch unter moderaten Winkeln auf den Wafer fallen im Gegensatz zu Beleuchtungssetting nach Figur 18.

Figuren 20 und 21 zeigen die Maskenstrukturen, die durch eine Doppelbelichtung bzw. Überblendung der Beleuchtungssettings nach Figuren 18 und 19, welche durch die optischen Baugruppen 28 und 29 bereitgestellt werden, während eines Scanvorgangs belichtet und mit guter Abbildungsqualität abgebildet werden können. Es handelt sich bei der Maskenstruktur nach Figur 20 um dichte vertikale Linien mit einer Ausdehnung in Y-Richtung mit 50 nm Breite und 50 nm Abstand der Linien in X-Richtung. Bei der Maskenstruktur nach Figur 21 handelt es sich um horizontale und vertikale Linien mit mehr als 100 nm Breite. Im letzteren Fall wird von sogenannten isolierten Linien gesprochen. Die gleichzeitige Abbildung von Strukturen nach den Fig. 20 und 21 ist ein typischer Anwendungsfall, bei dem auf einer Maske in einer Richtung kritische und gleichzeitig in der gleichen Richtung oder senkrecht dazu unkritische Strukturen in einer Belichtung auf den Wafer übertragen werden sollen. Kritisch wird hierbei im Sinne von kritisch für die Auflösung des Projektionsobjektivs verstanden und ist in der Regel gleichbedeutend mit geringer Breite der abzubildenden Struktur. Je nach dem, ob auf einer Maske die genannten dichten und isolierten Linien der Figuren 20 und 21 benachbart oder entfernt zueinander angebracht sind, wird sich die Doppelbelichtung oder die Überblendung bzw. eine Mischung aus Doppelbelichtung und Überblendung der Beleuchtungssettings nach Figuren 18 und 19 korreliert mit dem Scanvorgang für die Abbildung der Maskenstrukturen der Figuren 20 und 21 als optimal erweisen. Für die kontrastreiche Abbildung von einer Maske mit ausschließlich dichten Linien entsprechend der Maskenstruktur der Figur 20 eignet sich das Beleuchtungssetting nach Figur 18 und für die kontrastreiche Abbildung von einer Maske mit ausschließlich isolierten Linien entsprechend der Maskenstruktur der Figur 21 eignet sich das Beleuchtungssetting nach Figur 19.

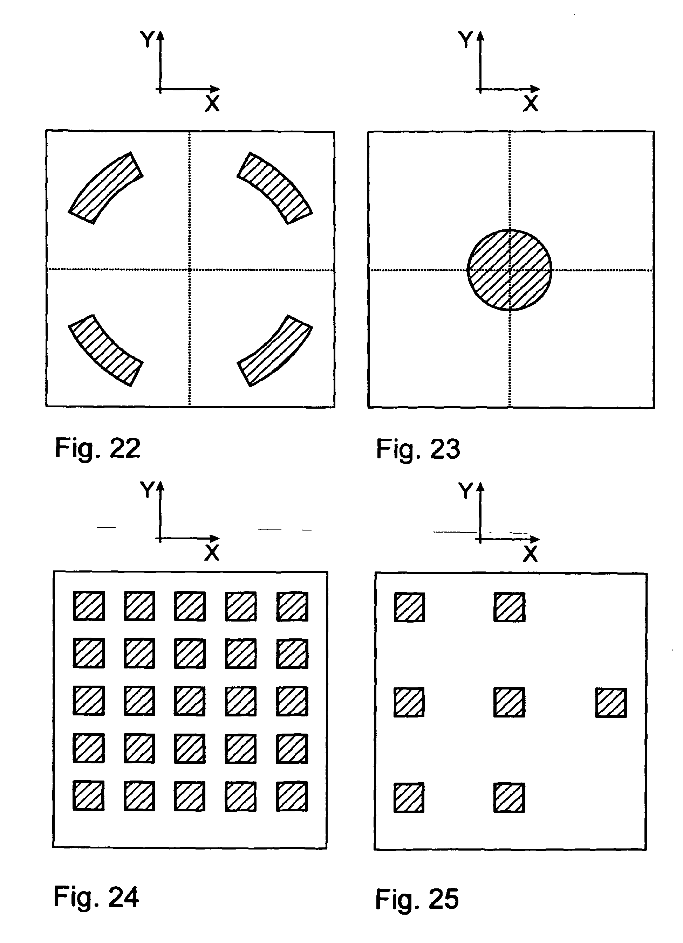

Figur 22 zeigt ein Beleuchtungssetting in Form einer Quasar- bzw. Quadrupol-Beleuchtung mit Polen mit einer Polbreite von 35° entlang der Diagonalen zwischen der X- und Y-Richtung mit einem inneren σ von 0.8 und einem äußeren σ von 0.99. Figur 23 zeigt ein Beleuchtungssetting in Form einer konventionellen Beleuchtung mit einem äußeren σ von 0.3. Hierbei kann das Beleuchtungssetting nach Figur 22 durch die Baugruppe 28 und das Beleuchtungssetting nach Figur 23 durch die Baugruppe 29 oder umgekehrt realisiert werden. Falls diese Beleuchtungssettings polarisiert betrieben werden sollen ist es von Vorteil, wenn das Beleuchtungssetting nach Figur 22 tangential zur optischen Achse linear polarisiert ist. Für die Polarisationsrichtung des Beleuchtungssetting nach Figur 23 gilt entsprechend das oben Gesagte zur Polarisationsrichtung des Beleuchtungssetting nach Figur 19.

Figuren 24 und 25 zeigen Maskenstrukturen, die durch eine Doppelbelichtung bzw. Überblendung der Beleuchtungssettings nach Figuren 22 und 23 während eines Scanvorgangs realisiert werden sollen. Es handelt sich hierbei um kritische (Figur 24) und unkritische (Figur 25) Kontaktlöcher mit einer Breite von zum Beispiel 65 nm. Kritisch ist hierbei gleichbedeutend mit einer hohen Packungsdichte von Kontaktlöchern auf der Maske. Je nach dem, ob auf einer Maske die genannten kritischen und unkritischen Kontaktlöcher der Figuren 24 und 25 benachbart oder entfernt zueinander angebracht sind, wird sich die Doppelbelichtung oder die Überblendung bzw. eine Mischung aus Doppelbelichtung und Überblendung der Beleuchtungssettings nach den Figuren 22 und 23 korreliert mit dem Scanvorgang für die Abbildung der Maskenstrukturen der Figuren 24 und 25 als optimal erweisen. Für die kontrastreiche Abbildung von einer Maske mit ausschließlich kritischen Kontaktlöchern entsprechend der Maskenstruktur der Figur 24 eignet sich das Beleuchtungssetting nach Figur 22 und für die kontrastreiche Abbildung von einer Maske mit ausschließlich unkritischen Kontaktlöchern entsprechend der Maskenstruktur der Figur 25 eignet sich das Beleuchtungssetting nach Figur 23 am besten.

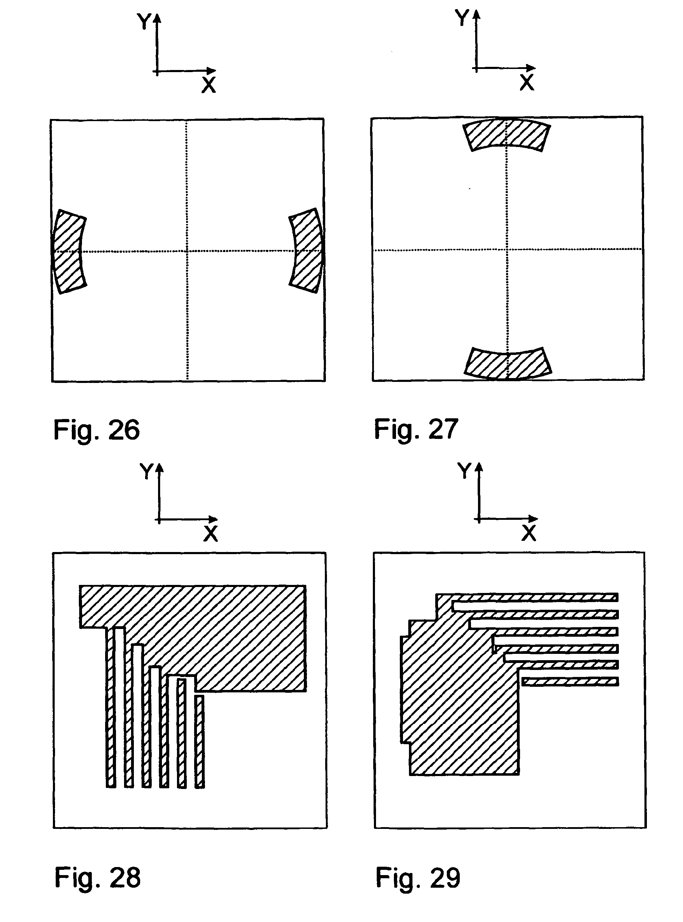

Figur 26 zeigt ein Beleuchtungssetting in Form einer X-Dipol-Beleuchtung mit Polen mit einer Polbreite von 35° in X-Richtung mit einem inneren σ von 0.8 und einem äußeren σ von 0.99. Figur 27 zeigt ein Beleuchtungssetting in Form einer Y-Dipol-Beleuchtung mit Polen mit einer Polbreite von 35° in Y-Richtung mit einem inneren σ von 0.8 und einem äußeren σ von 0.99. Hierbei kann das Beleuchtungssetting nach Figur 26 durch die Baugruppe 28 und das Beleuchtungssetting nach Figur 27 durch die Baugruppe 29 oder umgekehrt realisiert werden. Falls diese Beleuchtungssettings polarisiert betrieben werden sollen ist es von Vorteil, wenn das Beleuchtungssetting nach Figur 26 linear in Y-Richtung polarisiert ist und das Beleuchtungssetting nach Figur 27 linear in X-Richtung polarisiert ist.

Figuren 28 und 29 zeigen die beiden Masken, die durch eine Doppelbelichtung mit den Beleuchtungssettings nach den Figuren 26 und 27 während zweier Scanvorgängen nacheinander auf den gleichen zu belichtenden Wafer abgebildet werden sollen. Es handelt sich hierbei um dichte horizontale (Figur 28) und vertikale (Figur 29) Strukturen mit einer Breite von zum Beispiel 50 nm und einem Linienabstand von zum Beispiel 50 nm. Im Gegensatz zu den Beispielen oben wird zur Abbildung der beiden Masken nach den Figuren 28 und 29 eine Doppelbelichtung durchgeführt, bei der in einem ersten Schritt ein Scanvorgang mit der Maske nach Figur 28 und dem Beleuchtungssetting nach Figur 26 und in einem zweiten Schritt ein zweiter Scanvorgang mit der Maske nach Figur 29 und dem Beleuchtungssetting nach Figur 27 auf dem gleichen zu belichtenden Wafer durchgeführt wird. Somit erfolgen zwei unterschiedliche Belichtungen auf dem gleichen Wafer mit den unterschiedlichen Masken. Insofern unterscheidet sich diese Doppelbelichtung mit den unterschiedlichen Masken von der Doppelbelichtung bzw. Überblendung bei ein und derselben Maske, bei der nur das Beleuchtungssetting, mit dem die Maske beleuchtet wird, gewechselt wird. Hierbei ist es auch möglich, dass die beiden getrennten Masken nebeneinander in der Retikel- bzw. Maskenebene angeordnet sind und durch die Einrichtung 23 zum Halten und Manipulieren der Masken bzw. Retikel in Scanrichtung verfahren werden. In diesem Fall muss kein aufwändiger Maskenwechsel zwischen den beiden Belichtungen erfolgen und die Masken können nacheinander in einem Scanvorgang statt in zwei hintereinander durchgeführten, getrennten Scanvorgängen auf den gleichen zu belichtenden Wafer übertragen werden. Aufgrund der hohen Scangeschwindigkeit der Einrichtung 23, die für den hohen Wafer-Durchsatz der Projektionsbelichtungsanlage verantwortlich ist, ist es notwendig, die Beleuchtungssettings für die beiden Masken sehr schnell beim Übergang der Masken in dem einen Scanvorgang zu wechseln. Prinzipiell ist es nicht zwingend, dass die beiden getrennten Masken in der gleichen Ebene angeordnet sind. Grundsätzlich können die beiden Masken auch in verschiedenen Ebenen angeordnet sein, wobei die Anpassung der Projektionsbelichtungsanlage beim Wechsel zwischen den in verschiedenen Ebenen angeordneten Masken durch eine entsprechende und gegebenenfalls automatische Justage optischer Komponenten erfolgt.

Bei allen oben genannten Beleuchtungssettings nach den Figuren 18, 19, 22, 23 sowie 26, 27 ermöglicht es die erfindungsgemäße Doppel- oder Mehrfachbelichtung einer Maske mit den beiden Beleuchtungssettings nach den Figuren 18 und 19, 22 und 23, sowie 26 und 27 mit Schaltzeiten bis zu 1 ns bzw. die erfindungsgemäße Überblendung der beiden Settings die Lichtintensität innerhalb der beiden Settings genau zu kontrollieren und zu optimieren, so dass beim Scanvorgang mit einer Maskenstruktur nach den Figuren 20, 21, 24, 25 sowie 28, 29 bestmögliche Strukturen und Strukturbreiten auf dem zu belichtenden Wafer realisiert werden können. Hierbei ist es auch möglich, dass auf einer langsameren Zeitskala während des Scanvorgangs die beiden Zoom-Axikon-Gruppen 11,31 der beiden optischen Baugruppen 28, 29 nachgeregelt werden, um die inneren und äußeren minimalen bzw. maximalen Beleuchtungswinkel, vorgegeben durch die beiden jeweils genutzten Beleuchtungssettings, zu ändern.

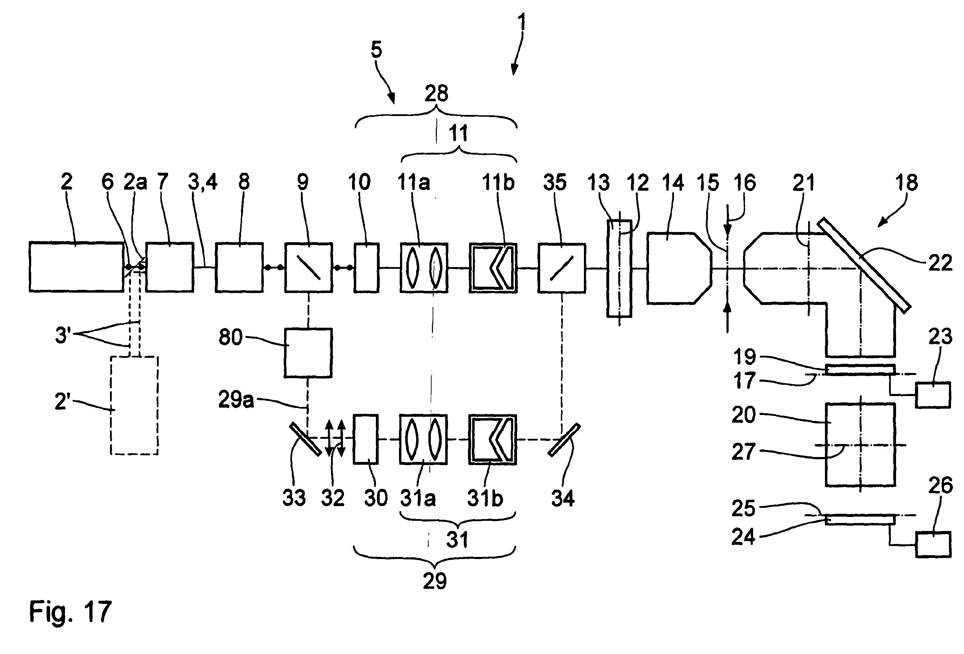

Ein weiterer Vorteil beim Betreiben der mindestens zwei optischen Baugruppen 28, 29 mit gleichen oder unterschiedlichen Beleuchtungssettings, mit gleichen oder unterschiedlichen Polarisationsverteilungen in der Pupillenebene 12 ergibt sich beim Schalten während des Lichtimpulses gemäß dem Schaltzeit-Beispiel nach Fig. 3, wenn innerhalb einer optischen Baugruppe 28 oder 29 eine optische Komponente 80 eingesetzt wird, welche den Teillichtimpuls der Baugruppe verzögert, siehe Fig. 17. Die optische Komponente 80 kann zum Beispiel aus einer entsprechend gefalteten optischen Verzögerungsstrecke aus mindestens zwei Spiegeln oder aus entsprechenden Äquivalenten bestehen, die es ermöglichen, die Laufzeit von Licht zu verlängern. Durch die Schaltung während des Lichtimpulses gemäß dem Schaltzeit-Beispiel nach Fig. 3 ist es möglich, wie oben schon erwähnt, aus einem Laser mit zum Beispiel 6 kHz Repetitionsrate einen Laser mit 12 kHz Repetitionsrate zu machen. Durch die optische Komponente 80 in Fig. 17 wird nun der Teillichtimpuls des Beleuchtungslichts in der optischen Baugruppe 29 gegenüber dem anderen Teillichtimpuls des Beleuchtungslichts in der anderen optischen Baugruppe 28 im Hinblick auf die Lichtlaufzeit derart verzögert, dass z.B. die Teillichtimpulse der einen Baugruppe 28 gegenüber den Teillichtimpulsen der anderen Baugruppe zeitlich derart zueinander versetzt sind, dass an dem zu belichtenden Retikel 19 zeitlich äquidistante Lichtpulse eintreffen. Hierbei werden die Lichtimpulse L₁, L₂ dort wo sie zu den Schaltzeitpunkten tₛ getrennt wurden, zeitlich um den Zeitabstand benachbarter Laserimpulse L verzögert, sodass alle durch das Schalten erzeugten Laserimpuls-Anteile L₁, L₂ nach dem Einkoppelelement gleiche zeitliche Abstände zueinander haben. Somit kann beispielsweise nicht nur ein 6 kHz Laser zu einem 12 kHz Laser auf gespalten werden, es kann z. B. auch die Dosis pro Zeitintervall des aufgespalteten 12 kHz Laser derart geregelt werden, dass sie der Dosis pro Zeitintervall eines realen 12 kHz Lasers weitestgehend entspricht. Dies ist für einen Scanvorgang mit gepulsten Lichtquellen wichtig, da sichergestellt werden muss, dass jeder Teilbereich eines Chips beim Scanvorgang die gleiche Dosis an Licht erhält. Wenn, wie oben erwähnt, die beiden Baugruppen 28, 29 anteilig, d.h. mit in ihrer Dosis unterschiedlichen Teillichtimpulsen in der zeitlichen Länge und/ oder mit verschiedener Intensität betrieben werden, so kann eine in der Zeit nicht äquidistante Pulsfolge der am Retikel 19 ankommenden Lichtimpulse von den beiden Baugruppen 28, 29 im Hinblick auf die Dosis sinnvoll sein.

Bei der oben erwähnten Polarisationseinstellung innerhalb der beiden optischen Baugruppen 28 und 29 oder dahinter sollte beachtet werden, dass diese nicht nur sinnvoll ist im Hinblick auf die Einstellung der räumlichen Polarisationsverteilung in der Pupillenebene 12 für die jeweiligen Beleuchtungssettings, wie z.B. nach den Figuren 18, 19, 22, 23 oder 26, 27, sondern auch sinnvoll ist, einen gewissen Polarisationszustand vorzuhalten, der durch die beiden optischen Baugruppen 28, 29 selbst, die nachfolgende Beleuchtungsoptik, das Retikel 19, das Projektionsobjektiv 20 und/ oder durch eine Fotolackschicht des zu belichtenden Wafers 24 geändert wird. Somit ist es möglich, den für eine kontrastreiche Abbildung jeweils nötigen Polarisationszustand am Wafer 24 bereitzustellen, selbst wenn im Lichtweg von den polarisationsbeeinflussenden optischen Elementen zum Wafer 24 eine Änderung des Polarisationszustandes erfolgt. Dieser Vorhalt einer räumlichen Polarisationsverteilung kann sich auch erst im Laufe des Betriebs einer Projektionsbelichtungsanlage als sinnvoll erweisen, wenn aufgrund von langsamen Änderungen der optischen Eigenschaften der optischen Elemente des Beleuchtungssystems 5 und des Projektionsobjektivs 20, sowie des Retikels 19 diese optischen Elemente den Polarisationszustand des durch sie hindurch tretenden Lichtes ändern. Derartige langsame Änderungen können beispielsweise durch thermische Drifts hervorgerufen werden.

Alternativ zur Schaltung der Polarisation mit einer Pockelszelle 8; 39 oder einer Kerrzelle, kann auch ein magneto-optischer Schalter auf Basis des Faraday-Effektes eingesetzt werden.

Alternativ zu den genannten Schaltungen bzw. Auskopplungen mit Hilfe der Lichtwellenlänge als wechselbare Lichteigenschaft können Raman-Zellen, wie in der US 4,458,994 beschrieben, oder Bragg-Zellen, wie in der US 5,453,814 beschrieben, benutzt werden. Hierfür kann auch ein photoelastischer Modulator (PEM) eingesetzt werden, wie er beispielsweise in der US 2004/0262500 A1 beschrieben ist.

Alternativ zu den genannten Möglichkeiten für Schaltungs- bzw. Auskopplungselemente, können auch Kombinationen der genannten Möglichkeiten eingesetzt werden, insbesondere Kombinationen, bei denen mindestens eine Komponente mittels eines elektro-optischen oder magneto-optischen Prinzips arbeitet.

## Patentansprüche

1. Beleuchtungssystem mit einer Beleuchtungsoptik für eine Mikrolithografie-Projektionsbelichtungsanlage (1) zur Ausleuchtung eines vorgegebenen Beleuchtungsfeldes einer Objektoberfläche (19) mit Beleuchtungslicht (3; 38) mindestens einer Lichtquelle (2; 36)
- mit einer ersten optischen Baugruppe (28) zur Einstellung eines ersten Beleuchtungssettings in einer Pupillenebene (12) der Beleuchtungsoptik,
- mit mindestens einer zweiten, von der ersten optischen Baugruppe (28) separaten optischen Baugruppe (29) zur Einstellung eines zweiten Beleuchtungssettings in der Pupillenebene (12) der Beleuchtungsoptik,
- mit mindestens einem im Lichtweg vor den beiden optischen Baugruppen (28, 29) angeordneten Auskoppelelement (9; 40; 60), das wahlweise das Beleuchtungslicht (3; 38) der ersten (28) und/oder der zweiten (29) optischen Baugruppe zuführt,
- mit mindestens einem im Lichtweg nach den beiden optischen Baugruppen (28, 29) angeordneten Einkoppelelement (35;68), das das Beleuchtungslicht (3; 38), welches die erste (28) und/oder die zweite (29) optische Baugruppe passiert hat, dem Beleuchtungsfeld zuführt,
- wobei das Beleuchtungslicht (3; 38) koaxial zu einer optischen Achse (4) der Beleuchtungsoptik ausgerichtet ist,
- wobei das Einkoppelelement (35; 68) so angeordnet ist, dass es das Beleuchtungslicht (3; 38), das auf einem Auskoppelast (29a) geführt wurde, so umlenkt, dass das Beleuchtungslicht (3; 38) nach dem Einkoppelelement (35; 68) exakt auf der optischen Achse (4) verläuft,
- mit einer zentralen Steuereinrichtung (43), die mit dem Auskoppelelement (9; 40; 60) in Signalverbindung steht und abhängig von einem Beleuchtungs-Vorgabewert das Auskoppelelement (9; 40; 60) zur anteiligen Beleuchtung des Beleuchtungsfeldes über die erste optische Baugruppe (28) und zur anteiligen Beleuchtung des Beleuchtungsfeldes über die zweite optische Baugruppe (29) ansteuert.

2. Beleuchtungssystem mit einer Beleuchtungsoptik für eine Mikrolithografie-Projektionsbelichtungsanlage (1) zur Ausleuchtung eines vorgegebenen Beleuchtungsfeldes einer Objektoberfläche (19) mit Beleuchtungslicht (3; 38) mindestens einer Lichtquelle (2; 36)
- mit einer ersten optischen Baugruppen (28) zur Einstellung eines ersten Beleuchtungssettings in einer Pupillenebene (12) der Beleuchtungsoptik,
- mit mindestens einer zweiten, von der ersten optischen Baugruppe (28) separaten optischen Baugruppe (29) zur Einstellung eines zweiten Beleuchtungssettings in der Pupillenebene (12) der Beleuchtungsoptik,
- mit mindestens einem im Lichtweg vor den beiden optischen Baugruppen (28, 29) angeordneten Auskoppelelement (9; 40; 60), das wahlweise das Beleuchtungslicht (3; 38) der ersten (28) und/oder der zweiten (29) optischen Baugruppe zuführt,
- mit mindestens einem im Lichtweg nach den beiden optischen Baugruppen (28, 29) angeordneten Einkoppelelement (35;68), das das Beleuchtungslicht (3; 38), welches die erste (28) und/oder die zweite (29) optische Baugruppe passiert hat, dem Beleuchtungsfeld zuführt,
- wobei das Beleuchtungslicht (3; 38) koaxial zu einer optischen Achse (4) der Beleuchtungsoptik ausgerichtet ist,
- wobei das Einkoppelelement (35; 68) so angeordnet ist, dass es das Beleuchtungslicht (3; 38), das auf einem Auskoppelast (29a) geführt wurde, so umlenkt, dass das Beleuchtungslicht (3; 38) nach dem Einkoppelelement (35; 68) exakt auf der optischen Achse (4) verläuft,
- wobei das Auskoppelelement als Auskoppel-Strahlteiler (9; 40) ausgeführt ist, der Licht mit einer ersten Lichteigenschaft der ersten optischen Baugruppe (28) und Licht mit einer zweiten Lichteigenschaft, die zur ersten Lichteigenschaft unterschiedlich ist, der zweiten optischen Baugruppe (29) zuführt,
- wobei das Einkoppelelement als Einkoppel-Strahlteiler (35) ausgeführt ist, der Beleuchtungslicht (3; 38), welches eine der beiden optischen Baugruppen (28, 29) passiert hat, dem Beleuchtungsfeld zuführt, wobei der Einkoppel-Strahlteiler (35) so angeordnet ist, dass Licht beider Lichteigenschaften nach dem Einkoppel-Strahlteiler (35) längs ein und derselben optischen Achse (4) zugeführt ist,
- wobei im Lichtweg vor dem Auskoppel-Strahlteiler (9; 40) eine schaltbare Lichteigenschafts-Wechseleinrichtung (8; 39) angeordnet ist, die Beleuchtungslicht (3; 38), das in die Lichteigenschafts-Wechseleinrichtung (8; 39) eintritt, je nach Schaltung in Licht mit der ersten und/oder der zweiten Lichteigenschaft überführt,
- mit einer zentralen Steuereinrichtung (43), die mit der Lichteigenschafts-Wechseleinrichtung (8; 39) in Signalverbindung steht und abhängig von einem Beleuchtungs-Vorgabewert die Lichteigenschafts-Wechseleinrichtung (8; 39) zur anteiligen Beleuchtung des Beleuchtungsfeldes über die erste optische Baugruppe (28) und zur anteiligen Beleuchtung des Beleuchtungsfeldes über die zweite optische Baugruppe (29) ansteuert.

3. Beleuchtungssystem nach Anspruch 2, **dadurch gekennzeichnet, dass** die Lichteigenschafts-Wechseleinrichtung (8; 39) so ausgestaltet ist, dass ein periodischer Wechsel der Lichteigenschaften erfolgt.

4. Beleuchtungssystem nach Anspruch 2 oder 3, **dadurch gekennzeichnet, dass**
- die Lichteigenschafts-Wechseleinrichtung als Polarisations-Wechseleinrichtung (72) ausgeführt ist, die zwischen mindestens zwei Betriebspositionen verlagerbar ist,
-- wobei in einer ersten Betriebsposition der Polarisations-Wechseleinrichtung (72) diese vom Beleuchtungslicht (3) derart passiert wird, dass das Beleuchtungslicht (3) der ersten optischen Baugruppe (28) zugeführt wird,
-- wobei in einer zweiten Betriebsposition der Polarisations-Wechseleinrichtung (72) diese vom Beleuchtungslicht (3) derart passiert wird, sodass das Beleuchtungslicht (3) der zweiten optischen Baugruppe (29) zugeführt wird.

5. Beleuchtungssystem nach einem der Ansprüche 2 bis 4, **dadurch gekennzeichnet, dass**
- die Lichteigenschafts-Wechseleinrichtung als Polarisations-Wechseleinrichtung (72) ausgeführt ist, die mindestens zwei voneinander räumlich getrennte, unterschiedlich wirkende polarisationsoptische Komponenten (74, 75) aufweist,
- wobei die Polarisations-Wechseleinrichtung (72) zwischen mindestens zwei Betriebspositionen verlagerbar ist,
-- wobei in einer ersten Betriebsposition eine erste (74) der polarisationsoptischen Komponenten der Polarisations-Wechseleinrichtung (72) vom Beleuchtungslicht (3) passiert wird, sodass das Beleuchtungslicht (3) der ersten optischen Baugruppe (28) zugeführt wird,
-- wobei in einer zweiten Betriebsposition eine zweite (75) der polarisationsoptischen Komponenten der Polarisations-Wechseleinrichtung (72) vom Beleuchtungslicht (3) passiert wird, sodass das Beleuchtungslicht (3) der zweiten optischen Baugruppe (29) zugeführt wird.

6. Beleuchtungssystem nach einem der Ansprüche 1 bis 5, **dadurch gekennzeichnet, dass** das Auskoppelelement (60) mindestens ein zwischen mindestens zwei Betriebspositionen verlagerbares Spiegelelement (67) umfasst, welches in mindestens einer ersten Betriebsposition das Beleuchtungslicht (3) der ersten optischen Baugruppe (28) und in mindestens einer zweiten Betriebsposition das Beleuchtungslicht (3) der zweiten optischen Baugruppe (29) zuführt,
wobei das Einkoppelelement (68) als synchron mit dem Auskoppelelement (60) verlagerbares Spiegelelement ausgeführt ist.

7. Beleuchtungssystem nach einem der Ansprüche 1 bis 6, **dadurch gekennzeichnet, dass** die erste optische Baugruppe (28) und die zweite optische Baugruppe (29) derart ausgebildet sind, dass sich das zweite Beleuchtungssetting vom ersten Beleuchtungssetting unterscheidet.

8. Beleuchtungssystem nach einem der Ansprüche 1 bis 7, **gekennzeichnet durch** eine optische Verzögerungskomponente (80) zur Verzögerung von Beleuchtungslicht, welches **durch** die erste optische Baugruppe geführt wird, relativ zum Beleuchtungslicht, welches **durch** die zweite optische Baugruppe geführt wird.

9. Beleuchtungssystem mit einer Beleuchtungsoptik nach einem der Ansprüche 2 bis 8
- mit mindestens einer Lichtquelle (2) zur Erzeugung von gepulstem Beleuchtungslicht (3),
- wobei die Lichteigenschafts-Wechseleinrichtung (8; 39) so ausgestaltet ist, dass mindestens ein Wechsel der Lichteigenschaft während eines Beleuchtungs-Lichtimpulses (L) erfolgt.

10. Beleuchtungssystem mit einer Beleuchtungsoptik nach einem der Ansprüche 2 bis 9,
- mit mindestens einer Lichtquelle (2) zur Erzeugung von gepulstem Beleuchtungslicht (3),
- wobei die Lichteigenschafts-Wechseleinrichtung (8; 39) so ausgestaltet ist, dass zwischen zwei aufeinander folgenden Lichtimpulsen diese Lichteigenschafts-Wechseleinrichtung (8; 39) zur Änderung der Lichteigenschaft betätigt wird.

11. Mikrolithografie-Projektionsbelichtungsanlage mit einem Beleuchtungssystem nach einem der Ansprüche 1 bis 10.

12. Verfahren zur mikrolithografischen Herstellung mikrostrukturierter Bauelemente mit folgenden Schritten:
- Bereitstellen eines Substrats (24), auf das zumindest teilweise eine Schicht aus einem lichtempfindlichen Material aufgebracht ist,
- Bereitstellung einer Maske (19), die abzubildende Strukturen aufweist,
- Bereitstellen einer Projektionsbelichtungsanlage (1) nach Anspruch 11,
- Projizieren wenigstens eines Teils der Maske (19) auf einen Bereich der Schicht mithilfe der Projektionsbelichtungsanlage (1).

13. Ergänzungsmodul für ein Beleuchtungssystem mit einer Beleuchtungsoptik für eine Mikrolithografie-Projektionsbelichtungsanlage
- mit einer optischen Ergänzungs-Baugruppe (29), die zusätzlich zu einer ersten optischen Baugruppe (28) der Beleuchtungsoptik zum Einsatz kommt und neben dem Beleuchtungssetting der ersten optischen Baugruppe (28) ein weiteres Beleuchtungssetting in einer Pupillenebene (12; 59) zur Verfügung stellt,
- mit mindestens einem Auskoppelelement (9; 40; 60), welches im Lichtweg vor den beiden optischen Baugruppen (28, 29) derart angeordnet werden kann, dass es
-- wahlweise das Beleuchtungslicht (3) der ersten optischen Baugruppe (28) oder der Ergänzungs-Baugruppe (29) zuführt,
- mit mindestens einem Einkoppelelement (35; 68), welches im Lichtweg nach den beiden optischen Baugruppen (28, 29) derart angeordnet werden kann, dass es
-- das Beleuchtungslicht (3), welches die erste optische Baugruppe (28) oder die Ergänzungs-Baugruppe (29) passiert hat, dem Beleuchtungsfeld zuführt,
- wobei das Beleuchtungslicht (3; 38) koaxial zu einer optischen Achse (4) der Beleuchtungsoptik ausgerichtet ist,
- wobei das Einkoppelelement (35; 68) so angeordnet ist, dass es das Beleuchtungslicht (3; 38), das auf einem Auskoppelast (29a) geführt wurde, so umlenkt, dass das Beleuchtungslicht (3; 38) nach dem Einkoppelelement (35; 68) exakt auf der optischen Achse (4) verläuft,
- mit einer zentralen Steuereinrichtung (43), die mit dem Auskoppelelement (9; 40; 60) in Signalverbindung steht und abhängig von einem Beleuchtungs-Vorgabewert das Auskoppelelement (9; 40; 60) zur anteiligen Beleuchtung des Beleuchtungsfeldes über die erste optische Baugruppe (28) und zur anteiligen Beleuchtung des Beleuchtungsfeldes über die zweite optische Baugruppe (29) ansteuert.

14. Ergänzungsmodul für ein Beleuchtungssystem mit einer Beleuchtungsoptik für eine Mikrolithografie-Projektionsbelichtungsanlage
- mit einer optischen Ergänzungs-Baugruppe (29), die zusätzlich zu einer ersten optischen Baugruppe (28) der Beleuchtungsoptik zum Einsatz kommt und neben dem Beleuchtungssetting der ersten optischen Baugruppe (28) ein weiteres Beleuchtungssetting in einer Pupillenebene (12; 59) zur Verfügung stellt,
- mit mindestens einem Auskoppelelement (9; 40; 60), welches im Lichtweg vor den beiden optischen Baugruppen (28, 29) derart angeordnet werden kann, dass es
-- wahlweise das Beleuchtungslicht (3) der ersten optischen Baugruppe (28) oder der Ergänzungs-Baugruppe (29) zuführt,
- mit mindestens einem Einkoppelelement (35; 68), welches im Lichtweg nach den beiden optischen Baugruppen (28, 29) derart angeordnet werden kann, dass es
- - das Beleuchtungslicht (3), welches die erste optische Baugruppe (28) oder die Ergänzungs-Baugruppe (29) passiert hat, dem Beleuchtungsfeld zuführt,
- wobei das Beleuchtungslicht (3; 38) koaxial zu einer optischen Achse (4) der Beleuchtungsoptik ausgerichtet ist,
- wobei das Einkoppelelement (35; 68) so angeordnet ist, dass es das Beleuchtungslicht (3; 38), das auf einem Auskoppelast (29a) geführt wurde, so umlenkt, dass das Beleuchtungslicht (3; 38) nach dem Einkoppelelement (35; 68) exakt auf der optischen Achse (4) verläuft,
- wobei das Auskoppelelement als Auskoppel-Strahlteiler (9; 40) ausgeführt ist, der Licht mit einer ersten Lichteigenschaft der ersten optischen Baugruppe (28) und Licht mit einer zweiten Lichteigenschaft, die zur ersten Lichteigenschaft unterschiedlich ist, der zweiten optischen Baugruppe (29) zuführt,
- wobei das Einkoppelelement als Einkoppel-Strahlteiler (35) ausgeführt ist, der Beleuchtungslicht (3; 38), welches eine der beiden optischen Baugruppen (28, 29) passiert hat, dem Beleuchtungsfeld zuführt, wobei der Einkoppel-Strahlteiler (35) so angeordnet ist, dass Licht beider Lichteigenschaften nach dem Einkoppel-Strahlteiler (35) längs ein und derselben optischen Achse (4) zugeführt ist,
- wobei im Lichtweg vor dem Auskoppel-Strahlteiler (9; 40) eine schaltbare Lichteigenschafts-Wechseleinrichtung (8; 39) angeordnet ist, die Beleuchtungslicht (3; 38), das in die Lichteigenschafts-Wechseleinrichtung (8; 39) eintritt, je nach Schaltung in Licht mit der ersten und/oder der zweiten Lichteigenschaft überführt,
- mit einer zentralen Steuereinrichtung (43), die mit der Lichteigenschafts-Wechseleinrichtung (8; 39) in Signalverbindung steht und abhängig von einem Beleuchttings-Vorgabewert die Lichteigenschafts-Wechseleinrichtung (8; 39) zur anteiligen Beleuchtung des Beleuchtungsfeldes über die erste optische Baugruppe (28) und zur anteiligen Beleuchtung des Beleuchtungsfeldes über die zweite optische Baugruppe (29) ansteuert.

## Claims

1. Illumination system with an illumination optics for a microlithographic projection exposure apparatus (1) for illuminating a specified illumination field of an object surface (19) with illumination light (3; 38) from at least one light source (2; 36)
- with a first optical module (28) for setting a first illumination setting in a pupil plane (12) of the illumination optics,
- with a least one second optical module (29), separate from the first optical module (28), for setting a second illumination setting in the pupil plane (12) of the illumination optics,
- with at least one decoupling element (9; 40; 60) located in the optical path upstream the two optical modules (28, 29) which optionally feeds the illumination light (3; 38) to the first optical module (28) and/or the second optical module (29),
- with at least one coupling element (35; 68) located in the optical path downstream from the two optical modules (28, 29) which feeds the illumination light (3; 38) which has passed through the first optical module (28) and/or the second optical module (29) to the illumination field,
- wherein the illumination light (3; 38) is coaxially aligned with an optical axis (4) of the illumination optics,
- wherein the coupling element (35; 68) is arranged such that it deflects the illumination light (3; 38) which was guided onto a decoupling path (29a) so that downstream from the coupling element (35; 68) the illumination light (3; 38) travels precisely along the optical axis (4),
- with a main control system (43) which is connected by signals to the decoupling element (9; 40; 60) and, depending on a specified illumination value, controls the decoupling element (9; 40; 60) to obtain proportional illumination of the illumination field via the first optical module (28) and obtain proportional illumination of the illumination field via the second optical module (29).

2. Illumination system with an illumination optics for a microlithographic projection exposure apparatus (1) for illuminating a specified illumination field of an object surface (19) with illumination light (3; 38) from at least one light source (2; 36)
- with a first optical module (28) for setting a first illumination setting in a pupil plane (12) of the illumination optics,
- with a least one second optical module (29), separate from the first optical module (28), for setting a second illumination setting in the pupil plane (12) of the illumination optics,
- with at least one decoupling element (9; 40; 60) located in the optical path upstream the two optical modules (28, 29) which optionally feeds the illumination light (3; 38) to the first optical module (28) and/or the second optical module (29),
- with at least one coupling element (35; 68) located in the optical path downstream from the two optical modules (28, 29) which feeds the illumination light (3; 38) which has passed through the first optical module (28) and/or the second optical module (29) to the illumination field,
- wherein the illumination light (3; 38) is coaxially aligned with an optical axis (4) of the illumination optics,
- wherein the coupling element (35; 68) is arranged such that it deflects the illumination light (3; 38) which was guided onto a decoupling path (29a) so that downstream from the coupling element (35; 68) the illumination light (3; 38) travels precisely along the optical axis (4),
- the decoupling element being designed as a decoupling beam splitter (9; 40) which feeds light with a first light characteristic to the first optical module (28) and light with a second light characteristic, which is different from the first light characteristic, to the second optical module (29),
- the coupling element being designed as a coupling beam splitter (35) which feeds the illumination light (3; 38) which has passed through one of the two optical modules (28, 29) to the illumination field, the coupling beam splitter (35) being arranged so that light having the two light characteristics downstream from the coupling beam splitter (35) travels along one and the same optical axis (4),
- a switchable light-characteristic changer (8; 39) being located in the optical path upstream from the decoupling beam splitter (9; 40) and changing the illumination light (3; 38) which enters light-characteristic changer (8; 39), depending on switching, into light having the first and/or second light characteristic
- with a main control system (43) which is connected by signals to the light-characteristic changer (8; 39) and, depending on a specified illumination value, controls the light-characteristic changer (8; 39) to obtain proportional illumination of the illumination field via the first optical module (28) and obtain proportional illumination of the illumination field via the second optical module (29).

3. Illumination optics according to claim 2, **characterised in that** light-characteristic changer (8; 39) is designed so that a periodic change in light characteristic takes place.

4. Illumination optics according to any one of claims 2 or 3, **characterised in that**
- the light-characteristic changer is designed as a polarisation changer (72) which can be moved between at least two operating positions,
-- wherein in a first operating position of the polarisation changer (72), the illumination light (3) passes through it so that the illumination light (3) is fed to first optical module (28),
-- wherein in a second operating position of the polarisation changer (72), the illumination light (3) passes through it so that the illumination light (3) is fed to the second optical module (29).

5. Illumination optics according to any one of claims 2 to 4, **characterised in that**
- the light-characteristic changer is designed as a polarisation changer (72) which has at least two spatially separate, differently acting polarisation optical components (74, 75),
- wherein the polarisation changer (72) can be moved between at least two operating positions,
-- wherein in a first operating position, the illumination light (3) passes through the first polarisation optical component (74) of the polarisation changer (72) so that the illumination light (3) is fed to the first optical module (3),
-- wherein in a second operating position, the illumination light (3) passes through the second optical component (75) of the polarisation changer (72) so that the illumination light (3) is fed to the second optical module (3).

6. Illumination optics according to any one of claims 1 to 5, **characterised in that** the decoupling element (60) includes at least one mirror element (67) which can be moved between at least two operating positions and, in at least a first operating position, feeds the illumination light (3) to the first optical module (28) and, in at least a second operating position, feeds the illumination light (3) to the second optical module (29), wherein the coupling element (68) is designed as a mirror element which can be moved in synchronism with the decoupling element (60).

7. Illumination optics according to any one of claims 1 to 6, **characterised in that** the first optical module (28) and the second optical module (29) are configured in such a way that the second illumination setting differs from the first illumination setting.

8. Illumination optics according to any one of claims 1 to 7, **characterised by** an optical delay component (80) for delaying illumination light fed through the first optical module relative to the illumination light fed through the second optical module.

9. Illumination system with an illumination optics according to any one of claims 2 to 8,
- with at least one light source (2) for generating pulsed illumination light (3),
- wherein the light-characteristic changer (8; 39) is designed so that at least one change of light characteristic takes place during one illumination light pulse (L).

10. Illumination system with an illumination optics according to any one of claims 2 to 9,
- with at least one light source (2) for generating pulsed illumination light (3),
- wherein the light-characteristic changer (8; 39) is designed so that this light-characteristic changer (8; 39) is actuated between two consecutive light pulses for altering the light characteristic.

11. Microlithographic projection exposure apparatus with an illumination system according to any one of claims 1 to 10.

12. Microlithographic fabrication method for microstructured components involving the following steps:
- providing a substrate (24) onto at least part of which a layer of a light-sensitive material has been applied,
- providing a mask (19) that includes the structures that are to be imaged,
- providing a projection exposure apparatus (1) according to claim 11,
- projecting at least part of the mask (19) onto a region of the layer using the projection exposure apparatus (1).

13. Supplementary module for an illumination optics with an illumination system for a microlithographic projection exposure apparatus
- with an optical module (29) which is used in addition to the first optical module (28) of the illumination optics and, alongside the illumination setting of the first optical module (28), provides another illumination setting at the pupil plane (12; 59),
- with at least one decoupling element (9; 40; 60) which is located in the optical path upstream from the two optical modules (28, 29) so that it
-- feeds the illumination light (3) either to the first optical module (28) or to supplementary module (29),
- with at least one coupling element (35; 68) which is located in the optical path downstream from the two optical modules (28, 29) so that it
-- feeds the illumination light (3) which has passed through the first optical module (28) or the supplementary module (29) to the illumination field,
- wherein the illumination light (3; 38) is coaxially aligned with an optical axis (4) of the illumination optics,
- wherein the coupling element (35; 68) is arranged such that it deflects the illumination light (3; 38) which was guided onto a decoupling path (29a) so that downstream from the coupling element (35; 68) the illumination light (3; 38) travels precisely along the optical axis (4),
- with a main control system (43) which is connected by signals to the decoupling element (9; 40; 60) and, depending on a specified illumination value, controls the decoupling element (9; 40; 60) to obtain proportional illumination of the illumination field via the first optical module (28) and obtain proportional illumination of the illumination field via the second optical module (29).

14. Supplementary module for an illumination optics with an illumination system for a microlithographic projection exposure apparatus
- with an optical module (29) which is used in addition to the first optical module (28) of the illumination optics and, alongside the illumination setting of the first optical module (28), provides another illumination setting at the pupil plane (12; 59),
- with at least one decoupling element (9; 40; 60) which is located in the optical path upstream from the two optical modules (28, 29) so that it
-- feeds the illumination light (3) either to the first optical module (28) or to supplementary module (29),
- with at least one coupling element (35; 68) which is located in the optical path downstream from the two optical modules (28, 29) so that it
-- feeds the illumination light (3) which has passed through the first optical module (28) or the supplementary module (29) to the illumination field,
- wherein the illumination light (3; 38) is coaxially aligned with an optical axis (4) of the illumination optics,
- wherein the coupling element (35; 68) is arranged such that it deflects the illumination light (3; 38) which was guided onto a decoupling path (29a) so that downstream from the coupling element (35; 68) the illumination light (3; 38) travels precisely along the optical axis (4),
- the decoupling element being designed as a decoupling beam splitter (9; 40) which feeds light with a first light characteristic to the first optical module (28) and light with a second light characteristic, which is different from the first light characteristic, to the second optical module (29),
- the coupling element being designed as a coupling beam splitter (35) which feeds the illumination light (3; 38) which has passed through one of the two optical modules (28, 29) to the illumination field, the coupling beam splitter (35) being arranged so that light having the two light characteristics downstream from the coupling beam splitter (35) travels along one and the same optical axis (4),
- a switchable light-characteristic changer (8; 39) being located in the optical path upstream from the decoupling beam splitter (9; 40) and changing the illumination light (3; 38) which enters light-characteristic changer (8; 39), depending on switching, into light having the first and/or second light characteristic
- with a main control system (43) which is connected by signals to the light-characteristic changer (8; 39) and, depending on a specified illumination value, controls the light-characteristic changer (8; 39) to obtain proportional illumination of the illumination field via the first optical module (28) and obtain proportional illumination of the illumination field via the second optical module (29).

## Revendications

1. Système d'éclairage comprenant une optique d'éclairage pour une installation d'éclairage par projection pour microlithographie (1) pour l'illumination d'un champ d'éclairement prédéterminé de la surface d'un objet (19) comprenant une lumière d'éclairement (3 ; 38) provenant d'au moins une source lumineuse (2 ; 36)
- comprenant un premier sous-ensemble optique (28) pour l'ajustement d'un premier réglage d'éclairage dans un plan de la pupille (12) de l'optique d'éclairage,
- comprenant au moins un second sous-ensemble optique (29), séparé du premier sous-ensemble optique (28), pour l'ajustement d'un second réglage de lumière dans le plan de la pupille (12) de l'optique d'éclairage,
- comprenant au moins un élément de déconnexion (9 ; 40 ; 60), disposé devant les deux sous-ensembles optiques (28, 29) sur le trajet de la lumière, qui adresse, au choix, la lumière d'éclairement (3 ; 38) vers le premier (28) et/ou vers le second (29) sous-ensemble optique,
- comprenant au moins un élément de connexion (35 ; 68), disposé après les deux sous-ensembles optiques (28, 29) sur le trajet de la lumière, qui adresse la lumière d'éclairement (3 ; 38), qui a passé par le premier (28) et/ou par le second (29) sous-ensemble optique, vers le champ d'éclairement,
- la lumière d'éclairement (3 ; 38) étant orientée de manière coaxiale par rapport à un axe optique (4) de l'optique d'éclairage,
- l'élément de connexion (35 ; 68) étant ainsi disposé que la lumière d'éclairement (3 ; 38), qui a été dirigée sur une branche de déconnexion (29a), est ainsi déviée que la lumière d'éclairement (3 ; 38) passe exactement par l'axe optique (4) après l'élément de connexion (35 ; 68),
- comprenant un équipement de pilotage (43) centralisé qui est en communication par signal avec l'élément de déconnexion (9 ; 40 ; 60) et qui, en fonction d'une valeur d'éclairement prédéterminée, met en marche l'élément de déconnexion (9 ; 40 ; 60) pour une contribution à l'illumination du champ d'éclairement par le premier sous-ensemble optique (28) et pour une contribution à l'illumination du champ d'éclairement par le second sous-ensemble optique (29).

2. Système d'éclairage comprenant une optique d'éclairage pour une installation d'éclairage par projection pour microlithographie (1) pour l'illumination d'un champ d'éclairement prédéterminé de la surface d'un objet (19) comprenant une lumière d'éclairement (3 ; 38) provenant d'au moins une source lumineuse (2 ; 36)
- comprenant un premier sous-ensemble optique (28) pour l'ajustement d'un premier réglage d'éclairage dans un plan de la pupille (12) de l'optique d'éclairage,
- comprenant au moins un second sous-ensemble optique (29), séparé du premier sous-ensemble optique (28), pour l'ajustement d'un second réglage de l'éclairage dans le plan de la pupille (12) de l'optique d'éclairage,
- comprenant au moins un élément de déconnexion (9 ; 40 ; 60), disposé devant les deux sous-ensembles optiques (28, 29) sur le trajet de la lumière, qui adresse, au choix, la lumière d'éclairement (3 ; 38) vers le premier (28) et/ou le second (29) sous-ensemble optique,
- comprenant au moins un élément de connexion (35 ; 68), disposé après les deux sous-ensembles d'optiques (28, 29) sur le trajet de la lumière, qui adresse vers le champ d'éclairement la lumière d'éclairement (3 ; 38) qui a passé par le premier (28), et/ou par le second (29) sous-ensemble optique,
- la lumière d'éclairement (3 ; 38) étant orientée de manière coaxiale par rapport à un axe optique (4) de l'optique d'éclairage,
- l'élément de connexion (35 ; 68) étant disposé de telle manière que la lumière d'éclairement (3 ; 38), qui a été dirigée sur une branche de déconnexion (29a), est ainsi déviée que la lumière d'éclairement (3 ; 38) passe exactement par l'axe optique (4) après l'élément de connexion (35 ; 68),
- l'élément de déconnexion étant conçu sous la forme d'un séparateur de faisceaux de déconnexion (9 ; 40) qui adresse de la lumière avec une première propriété de la lumière vers le premier sous-ensemble optique (28), et de la lumière, avec une seconde propriété de lumière, qui est différente de la première propriété de la lumière, vers le second sous-ensemble optique (29),
- l'élément de connexion étant conçu sous la forme d'un séparateur de faisceaux de connexion (35) qui adresse vers le champ d'éclairement la lumière d'éclairement (3 ; 38) qui a passé par l'un des deux sous-ensembles optiques (28, 29), le séparateur de faisceaux de connexion (35) étant ainsi disposé que la lumière, ayant les deux propriétés de lumière, est adressée, après le séparateur de faisceaux de connexion (35), le long d'un seul et même axe optique (4),
- un équipement de variation des propriétés de la lumière (8 ; 39), pouvant être commuté, étant disposé sur le trajet de la lumière avant le séparateur de faisceaux de déconnexion (9 ; 40), équipement qui transfère la lumière d'éclairement (3 ; 38), qui pénètre dans l'équipement de variation des propriétés de la lumière (8 ; 39), en fonction du réglage en luminosité, dans la première et/ou dans la seconde propriété de la lumière,
- comprenant une équipement de pilotage (43) centralisé qui est en liaison par signal avec l'équipement de variation des propriétés de la lumière (8 ; 39) et qui, en fonction d'une valeur d'éclairage prédéterminée, met en marche l'équipement de variation des propriétés de la lumière (8 ; 39) pour une contribution à l'illumination du champ d'éclairement par le premier sous-ensemble optique (28) et pour la contribution à l'illumination du champ d'éclairement par le second sous-ensemble optique (29).

3. Système d'éclairage selon la revendication 2 **caractérisé en ce que** l'équipement de variation des propriétés de la lumière (8 ; 39) est ainsi conçu qu'il se produit une variation périodique des propriétés de la lumière.

4. Système d'éclairage selon les revendications 2 ou 3 **caractérisé en ce que**
- l'équipement de variation des propriétés de la lumière est conçu sous la forme d'un équipement de variation de polarisation (72) qui peut être déplacé entre au moins deux positions de fonctionnement, où
-- dans une première position de fonctionnement de l'équipement de variation de polarisation, celui-ci est ainsi traversé par la lumière d'éclairement (3) que la lumière d'éclairement (3) est adressée au premier sous-ensemble optique (28),
-- dans une seconde position de fonctionnement de l'équipement de variation de polarisation, celui-ci est ainsi traversé par la lumière d'éclairement (3) que la lumière d'éclairement (3) est adressée au second sous-ensemble optique (29).

5. Système d'éclairage selon l'une des revendications 2 à 4 **caractérisé en ce que**
- l'équipement de variation des propriétés de la lumière est conçu sous la forme d'un équipement de variation de polarisation (72) qui présente au moins deux composantes optiques de polarisation (74 ; 75) agissant de manière différente, séparée l'une de l'autre dans l'espace,
- l'équipement de variation de la polarisation (72) pouvant être déplacé entre au moins deux positions de fonctionnement, où
-- dans une première position de fonctionnement, une première (74) composante de polarisation optique de l'équipement de variation de la polarisation (72) est traversée par la lumière d'éclairement (3) de sorte que la lumière d'éclairement (3) est adressée au premier sous-ensemble optique (28),
-- dans une seconde position de fonctionnement, une seconde (75) parmi les composantes de polarisation optique de l'équipement de variation de polarisation (72) est traversée par la lumière d'éclairement (3) de sorte que la lumière d'éclairement (3) est adressée au second sous-ensemble optique (29).

6. Système d'éclairage selon l'une des revendications de 1 à 5 **caractérisé en ce que** l'élément de déconnexion (60) comprend au moins un élément miroir (67), pouvant être déplacé entre au moins deux positions de fonctionnement, qui adresse, dans au moins une première position de fonctionnement, la lumière d'éclairement (3) vers le premier sous-ensemble optique (28), et dans au moins une seconde position de fonctionnement, adresse la lumière d'éclairement (3) vers le second sous-ensemble optique (29),
l'élément de connexion (68) étant conçu synchrone avec l'élément miroir, pouvant être déplacé avec l'élément de déconnexion (60).

7. Système d'éclairage selon l'une des revendications 1 à 6 **caractérisé en ce que** le premier sous-ensemble optique (28) et le second sous-ensemble optique (29) sont conçus de telle manière que le second réglage d'éclairage se différencie du premier réglage d'éclairage.

8. Système d'éclairage selon l'une des revendications 1 à 7 **caractérisé par** une composante de retardement optique (80) pour le décalage de la lumière d'éclairement qui est adressée à travers le premier sous-ensemble optique, relativement par rapport à la lumière d'éclairement qui est adressée à travers le second sous-ensemble optique.

9. Système d'éclairage comprenant une optique d'éclairage selon l'une des revendications 2 à 8
- comprenant au moins une source lumineuse (2) pour la génération d'une lumière d'éclairement (3) à impulsions,
- l'équipement de variation des propriétés de la lumière (8 ; 39) étant ainsi conçu qu'au moins une variation de la propriété de la lumière se produise pendant une impulsion de lumière d'éclairement (L).

10. Système d'éclairage comprenant une optique d'éclairage selon l'une des revendications 2 à 9,
- comprenant au moins une source lumineuse (2) pour la génération d'une lumière d'éclairement par impulsions (3),
- l'équipement de variation des propriétés de la lumière (8 ; 39) étant ainsi conçu, qu'entre deux impulsions de lumières consécutives, cet équipement de variation des propriétés de la lumière (8 ; 39) est actionné pour la modification de la propriété de la lumière.

11. Installation d'éclairage par projection pour microlithographie comprenant un système d'éclairage selon l'une des revendications de 1 à 10.

12. Procédé pour la fabrication pour microlithographie de sous-ensembles microstructurés comprenant les étapes suivantes :
- préparation d'un substrat (24) sur lequel est rapportée au moins partiellement une couche constituée d'un matériau sensible à la lumière,
- préparation d'un masque (19) qui présente des structures à représenter,
- préparation d'une installation d'éclairage par projection (1) selon la revendication 11,
- projection d'au moins une partie du masque (19) sur une zone de la couche à l'aide d'une installation d'éclairage par projection (1).

13. Module complémentaire pour un système d'éclairage comprenant une optique d'éclairage pour une installation d'éclairage par projection pour microlithographie
- comprenant un sous-ensemble optique complémentaire (29) qui arrive à être employé complémentairement à un premier sous-ensemble optique (28) de l'optique d'éclairage et qui met à disposition un autre réglage de la lumière dans un plan de la pupille (12 ; 59) en supplément au réglage d'éclairage du premier sous-ensemble optique (28),
- comprenant au moins un élément de déconnexion (9 ; 40 ; 60) qui peut être disposé de telle manière sur le trajet de la lumière avant les deux sous-ensembles optiques (28, 29) qu'il
-- adresse, au choix, la lumière d'éclairement (3) vers le premier sous-ensemble optique (28) ou vers le sous-ensemble complémentaire (29),
- comprenant au moins un élément de connexion (35 ; 68) qui peut être disposé sur le trajet de la lumière après les deux sous-ensembles optiques (28, 29) de telle manière qu'il
-- adresse la lumière d'éclairement (3), qui a passé par le premier sous-ensemble optique (28) par ou le sous-ensemble complémentaire (29), vers le champ d'éclairement,
- la lumière d'éclairement (3 ; 38) étant orientée de manière coaxiale par rapport à un axe optique (4) de l'optique d'éclairage,
- l'élément de connexion (35 ; 68) étant ainsi disposé qu'il dévie la lumière d'éclairement (3 ; 38) qui a été menée sur une branche de déconnexion (29a), de telle manière que la lumière d'éclairement (3 ; 38) passe exactement par l'axe optique (4), après l'élément de connexion (35 ; 68),
- comprenant un équipement de pilotage centralisé (43) qui est en relation par signal avec l'élément de déconnexion (9 ; 40 ; 60) et pilote l'élément de déconnexion (9 ; 40 ; 60) en fonction d'une valeur prédéterminée d'éclairage pour la contribution d'éclairage du champ d'éclairement par le premier sous-ensemble optique ((28) et pour la contribution à l'éclairage par le second sous-ensemble optique (29).

14. Module complémentaire pour un système d'éclairage comprenant une optique d'éclairage pour une installation d'éclairage par projection pour microlithographie
- comprenant un sous-ensemble optique complémentaire (29) qui vient à être employé complémentairement à un premier sous-ensemble optique (28) de l'optique d'éclairage et met à disposition un autre réglage d'éclairage dans un plan de la pupille (12 ; 59), à côté d'un réglage d'éclairage du premier sous-ensemble optique (28),
- comprenant au moins un élément de déconnexion (9 ; 40 ; 60) qui peut être disposé sur le trajet de la lumière avant les deux sous-ensembles optiques (28, 29) de telle manière
-- qu'il adresse, au choix, la lumière d'éclairement (3) au premier sous-ensemble optique (28) ou au sous-ensemble complémentaire (29),
- comprenant au moins un élément de connexion (35 ; 68) qui peut être ainsi disposé sur le trajet de la lumière après les deux sous-ensembles optiques (28, 29) que
-- la lumière d'éclairement (3), qui a traversé le premier sous-ensemble optique (28) ou le sous-ensemble complémentaire (29), est adressée au champ d'éclairement,
- la lumière d'éclairement (3 ; 38) étant orientée de manière coaxiale par rapport à un axe optique (4) de l'optique d'éclairage,
- l'élément de connexion (35 ; 68) étant ainsi disposé que la lumière d'éclairement (3 ; 38), qui a été adressée sur une branche de déconnexion (29a), est ainsi déviée que la lumière d'éclairement (3 ; 38) passe exactement par l'axe optique (4) après l'élément de connexion (35 ; 68),
- l'élément de déconnexion étant conçu sous la forme d'un séparateur de faisceaux de déconnexion (9 ; 40), qui adresse de la lumière avec une première propriété de lumière au premier sous-ensemble optique (28) et de la lumière avec une seconde propriété de lumière, qui est différente de la première propriété de lumière, au deuxième sous-ensemble optique (29),
- l'élément de connexion étant conçu sous la forme d'un séparateur de faisceaux de connexion (35) qui adresse de la lumière d'éclairement (3 ; 38), qui a passé par l'un des deux sous-ensembles optiques (28 , 29), vers le champ d'éclairement, le séparateur de faisceaux de connexion (35) étant ainsi disposé que de la lumière ayant les deux propriétés de lumière est adressée le long et vers le même axe optique (4) après le séparateur de faisceaux de connexion (35),
- un équipement de variation des propriétés de la lumière (8 ; 39) réglable étant disposé sur le trajet de la lumière avant le séparateur de faisceaux de déconnexion (9 ; 40), équipement qui adresse la lumière d'éclairement (3 ; 38), qui pénètre dans l'équipement de variation des propriétés de la lumière (8 ; 38), selon le réglage en lumière, à la première et/ou à la seconde propriété de lumière,
- comprenant une équipement de pilotage centralisé (43), qui est en liaison par signal avec l'équipement de variation des propriétés de la lumière (8 ; 39) et qui oriente, en fonction d'une valeur prédéterminée d'éclairage, l'équipement de variation des propriétés de la lumière (8 ; 39) pour une contribution à l'éclairage du champ d'éclairement par le premier sous-ensemble optique (28) et pour une contribution à l'éclairage du champ d'éclairement par le second sous-ensemble optique (29).
